(19) Europäisches Patentamt
European Patent Office
Office européen des brevets

(11) **EP 4 071 819 A1**

(12) **EUROPEAN PATENT APPLICATION**
published in accordance with Art. 153(4) EPC

(43) Date of publication:
**12.10.2022 Bulletin 2022/41**

(21) Application number: **20911103.8**

(22) Date of filing: **31.12.2020**

(51) International Patent Classification (IPC):
**H01L 27/146** (2006.01)

(52) Cooperative Patent Classification (CPC):
**H01L 27/146**

(86) International application number:
**PCT/CN2020/141893**

(87) International publication number:
**WO 2021/136469 (08.07.2021 Gazette 2021/27)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **31.12.2019 PCT/CN2019/130438
19.11.2020 PCT/CN2020/130020**

(71) Applicant: **Huawei Technologies Co., Ltd.
Shenzhen, Guangdong 518129, (CN)**

(72) Inventors:
• **ZHANG, Youming**
**Shenzhen, Guangdong 518129 (CN)**
• **SUN, Shang**
**Shenzhen, Guangdong 518129 (CN)**
• **LIU, Chuangchuang**
**Shenzhen, Guangdong 518129 (CN)**

(74) Representative: **Gill Jennings & Every LLP
The Broadgate Tower
20 Primrose Street
London EC2A 2ES (GB)**

(54) **IMAGE SENSOR, LIGHT SPLITTING COLOR FILTER DEVICE, AND IMAGE SENSOR FABRICATION METHOD**

(57) Embodiments of this application provide an image sensor, a spectrum splitting and filtering device, and an image sensor preparation method, so as to improve utilization of light that is incident to an image sensor. The image sensor includes a metasurface, a substrate, and an optical-to-electrical conversion unit. Arrays in the metasurface are arranged on the top of the substrate. The metasurface includes a plurality of subunits. Each subunit includes an array including a plurality of columnar structures. The bottom of the substrate is disposed on a surface of the optical-to-electrical conversion unit in the image sensor. The metasurface includes at least two media with different refractive indexes. Each color unit corresponds to one of the plurality of subunits. The optical-to-electrical conversion unit includes an array for optical-to-electrical conversion. The array of the optical-to-electrical conversion unit is divided into a plurality of color regions. The metasurface is configured to refract incident light and transmit, through the substrate, refracted light to a corresponding color region in the array of the optical-to-electrical conversion unit. In addition, each subunit refracts incident light and then transmits refracted light to a color region in a corresponding color unit.

FIG. 8

## Description

This application claims priority to Chinese Patent Application No. PCT/CN2019/130438, filed with the China National Intellectual Property Administration on December 31, 2019 and entitled "IMAGE SENSOR AND PREPARATION METHOD THEREOF, AND ELECTRONIC DEVICE", which is incorporated herein by reference in its entirety.

This application further claims priority to Chinese Patent Application No. PCT/CN2020/130020, filed with the China National Intellectual Property Administration on November 19, 2020 and entitled "IMAGE SENSOR, SPECTRUM SPLITTING and FILTERING DEVICE, AND IMAGE SENSOR PREPARATION METHOD", which is incorporated herein by reference in its entirety.

## TECHNICAL FIELD

This application relates to the imaging field, and in particular, to an image sensor, a spectrum splitting and filtering device, and an image sensor preparation method.

## BACKGROUND

Image sensors can convert optical images into electrical signals, and are widely applied to various electronic devices, for example, digital cameras. Hardware of a digital camera mainly includes a lens module, an image sensor, an electrical signal processor, and the like. The lens module is configured to image an optical image on the image sensor. The image sensor is configured to convert an optical signal of the image into an analog electrical signal, and input the analog electrical signal to the electrical signal processor. The electrical signal processor converts the analog electrical signal into a digital signal, and outputs a photo after data processing. As an optical-to-electrical converter, the image sensor is one of core components of the digital camera, and performance of the image sensor directly determines quality of the output photo.

An optical-to-electrical conversion element of the image sensor can convert optical signals with different intensities into electrical signals with different intensities. However, the optical-to-electrical conversion element itself cannot distinguish frequencies of light, that is, cannot distinguish colors. Therefore, an image directly obtained by using an image sensor without a color collection layer is black and white. For a purpose of obtaining a color picture, a color filtering system needs to be used as a color collection layer to obtain color information of the picture. For example, based on a characteristic that a human eye is sensitive to a red green blue (red green blue, RGB) spectrum, RGB color filters are arranged on the optical-to-electrical conversion element to form an RGB-mosaic Bayer color filter system, so that a color picture can be obtained. However, in a conventional solution, light utilization is comparatively low, for example, total light utilization in the case of white light incidence is only approximately 25%, light utilization in the case of red light or blue light incidence is only approximately 15%, and light utilization in the case of green light incidence is approximately 30%. Therefore, how to improve light utilization becomes an urgent problem to be resolved.

## SUMMARY

Embodiments of this application provide an image sensor, a spectrum splitting and filtering device, and an image sensor preparation method, so as to improve utilization of light that is incident to an image sensor.

In view of this, a first aspect of this application provides an image sensor, including a metasurface, a substrate, and an optical-to-electrical conversion unit. The metasurface includes a plurality of subunits. Each subunit includes an array including a plurality of columnar structures. Arrays in the metasurface are arranged on the top of the substrate. The bottom of the substrate is disposed on a surface (also referred to as the top) of the optical-to-electrical conversion unit. The metasurface includes at least two media with different refractive indexes. The optical-to-electrical conversion unit includes an array for optical-to-electrical conversion. The array of the optical-to-electrical conversion unit is divided into a plurality of color regions. The metasurface is configured to refract incident light and transmit, through the substrate, refracted light to a corresponding color region in the array of the optical-to-electrical conversion unit.

The array of the optical-to-electrical conversion unit may be divided into a plurality of color units, each color unit includes at least four color regions, each color unit corresponds to one subunit, and each subunit refracts incident light and then transmits refracted light to a color region in a corresponding color unit.

Therefore, in this implementation of this application, incident light may be refracted by using the array including the at least two media with different refractive indexes on the metasurface, so that light of different spectrum bands can be refracted to corresponding color regions in the optical-to-electrical conversion unit, thereby improving light utilization. In addition, compared with a case in which a Bayer color filter is disposed, the metasurface of the image sensor provided in this application can refract light of a plurality of different spectrum bands to corresponding color regions, thereby avoiding a problem of low light utilization caused by filtering. This may be understood as follows: The metasurface can diffract incident light, so that light of different spectrum bands can be transmitted to corresponding color regions in the optical-to-electrical conversion unit, thereby improving light utilization.

In a possible implementation, a color filtering structure is further disposed between the optical-to-electrical conversion unit and the substrate, the color filtering structure is divided into a plurality of color filtering regions, each color filtering region covers one corresponding color region, and a color corresponding to each color region is the same as a color that passes through a color filtering region covering the color region.

In this implementation of this application, the color filtering structure may be further disposed between the optical-to-electrical conversion unit and the substrate, to filter out signals different from those of light of spectrum bands corresponding to the color regions, thereby reducing crosstalk.

In a possible implementation, a lens is further disposed between each color filtering region and the substrate. In this application, the lens may be further disposed between each color filtering region and the substrate, to converge light incident to the color filtering region.

In a possible implementation, light of a plurality of spectrum bands corresponding to the plurality of color regions includes one or more of green, red, blue, or infrared light. Therefore, in this implementation of this application, the optical-to-electrical conversion unit can convert optical signals of a plurality of spectrum bands into electrical signals, so as to generate images of more color channels subsequently.

In a possible implementation, a material of the metasurface includes one or more of the following: titanium dioxide, gallium nitride, or silicon carbide.

In a possible implementation, colors corresponding to each color unit include at least two same colors, and columnar structures included in a region that corresponds to each color unit and that is in the metasurface form an angularly symmetric shape.

Therefore, every four color regions arranged into a matrix may correspond to at least two same colors, and colors corresponding to two symmetric color regions may be the same. This embodiment provides a possible arrangement manner applicable to the arrays of the metasurface.

According to a second aspect, this application provides a spectrum splitting and filtering device, including a metasurface and a substrate.

The metasurface includes a plurality of subunits. Each subunit includes an array including a plurality of columnar structures. Arrays in the metasurface are arranged on the top of the substrate. The metasurface includes at least two media with different refractive indexes. The metasurface is configured to refract incident light. The substrate is configured to transmit light refracted by the metasurface.

Therefore, in this implementation of this application, incident light may be refracted by using the array including the at least two media with different refractive indexes on the metasurface, so that light of different spectrum bands can be refracted to different regions, thereby improving light utilization. In addition, compared with a case in which a Bayer color filter is disposed, the metasurface of the spectrum splitting and filtering device provided in this application can refract light of a plurality of different spectrum bands to corresponding color regions, thereby avoiding a problem of low light utilization caused by filtering.

In a possible implementation, the spectrum splitting and filtering device may be applied to an image sensor. The image sensor includes an optical-to-electrical conversion unit. The substrate is disposed on a surface of the optical-to-electrical conversion unit. The optical-to-electrical conversion unit includes an array for optical-to-electrical conversion. The array of the optical-to-electrical conversion unit is divided into a plurality of color regions. The metasurface refracts incident light and transmits, through the substrate, refracted light to a corresponding color region in the array of the optical-to-electrical conversion unit. This may be understood as follows: The metasurface can diffract incident light, so that light of different spectrum bands can be transmitted to corresponding color regions in the optical-to-electrical conversion unit, thereby improving light utilization.

The array of the optical-to-electrical conversion unit may be divided into a plurality of color units, each color unit includes at least four color regions, each color unit corresponds to one subunit in the metasurface, and each subunit refracts incident light and then transmits refracted light to a color region in a corresponding color unit. In a possible implementation, a color filtering structure is further disposed between the optical-to-electrical conversion unit and the substrate, the color filtering structure is divided into a plurality of color filtering regions, each color filtering region covers one corresponding color region, and a color corresponding to each color region is the same as a color that passes through a color filtering region covering the color region. In this implementation of this application, the color filtering structure may be further disposed between the optical-to-electrical conversion unit and the substrate, to filter out signals different from those of light of spectrum bands corresponding to the color regions, thereby reducing crosstalk.

In a possible implementation, a lens is further disposed between each color filtering region and the substrate. In this application, the lens may be further disposed between each color filtering region and the substrate, to converge light incident to the color filtering region.

In a possible implementation, light of a plurality of spectrum bands of colors corresponding to the plurality of color regions includes one or more of green, red, blue, or infrared light. Therefore, in this implementation of this application, the optical-to-electrical conversion unit can convert optical signals of a plurality of spectrum bands into electrical signals, so as to generate images of more color channels subsequently.

In a possible implementation, a material of the metasurface includes one or more of the following: titanium dioxide, gallium nitride, or silicon carbide.

In a possible implementation, colors corresponding to each color unit include at least two same colors, and columnar structures included in a region that corresponds to each color unit and that is in the metasurface form an angularly symmetric shape.

According to a third aspect, this application provides an image sensor preparation method, including:

preparing an optical-to-electrical conversion unit, where the optical-to-electrical conversion unit is configured to convert an optical signal into an electrical signal, the optical-to-electrical conversion unit includes an array for optical-to-electrical conversion, and the array of the optical-to-electrical conversion unit is divided into a plurality of color regions; and preparing a spectrum splitting and filtering device on a surface of the optical-to-electrical conversion unit, where the spectrum splitting and filtering device includes a metasurface and a substrate, the metasurface includes a plurality of subunits, each subunit includes an array including a plurality of columnar structures, arrays in the metasurface are arranged on the top of the substrate, the bottom of the substrate is disposed on the surface of the optical-to-electrical conversion unit, the metasurface includes at least two media with different refractive indexes, the optical-to-electrical conversion unit includes the array for optical-to-electrical conversion, the surface of the optical-to-electrical conversion unit is a face for receiving an optical signal, the array of the optical-to-electrical conversion unit is divided into a plurality of color regions, and the metasurface is configured to refract incident light to a corresponding color region in the array of the optical-to-electrical conversion unit.

The array of the optical-to-electrical conversion unit may be divided into a plurality of color units, each color unit includes at least four color regions, each color unit corresponds to one subunit in the metasurface, and each subunit refracts incident light and then transmits refracted light to a color region in a corresponding color unit. Therefore, in this implementation of this application, the metasurface of the spectrum splitting and filtering device in an image sensor obtained through preparation has the array including the at least two media with different refractive indexes, to refract incident light, so that light of different spectrum bands can be refracted to corresponding color regions in the optical-to-electrical conversion unit, thereby improving light utilization. In addition, compared with a case in which a Bayer color filter is disposed, the metasurface of the spectrum splitting and filtering device provided in this application can refract light of a plurality of different spectrum bands to corresponding color regions, thereby avoiding a problem of low light utilization caused by filtering.

In a possible implementation, before the preparing a spectrum splitting and filtering device on a surface of the optical-to-electrical conversion unit, the method further includes: determining a plurality of arrays, and using the plurality of arrays as a structure of the metasurface of the spectrum splitting and filtering device, to obtain a plurality of spectrum splitting structures; obtaining a plurality of evaluation values in one-to-one correspondence with the plurality of spectrum splitting structures by using a preset evaluation function, where the evaluation function is a function for calculating light utilization of the spectrum splitting structures; and if the plurality of evaluation values include at least one evaluation value greater than a preset value, selecting a first spectrum splitting structure as a structure of the spectrum splitting and filtering device from the plurality of spectrum splitting structures, where an evaluation value of the first spectrum splitting structure is greater than the preset value.

Therefore, in this implementation of this application, light utilization of each array may be calculated by using a pre-established simulation model, so as to obtain an array whose light utilization exceeds the preset value, and further obtain, through preparation, an image sensor whose light utilization exceeds the preset value. This may be understood as follows: An array that meets a light utilization requirement target may be reversely obtained based on the specified light utilization requirement target by using an optimization algorithm such as a genetic algorithm, a simulated annealing algorithm, or gradient descent, so as to improve light utilization of the spectrum splitting and filtering device and the image sensor.

In a possible implementation, the method may further include: if the plurality of evaluation values do not include at least one evaluation value greater than a preset value, determining a plurality of arrays anew, and determining a spectrum splitting structure as a structure of the spectrum splitting and filtering device based on the plurality of arrays determined anew.

Therefore, in this implementation of this application, if the plurality of arrays include no array whose evaluation value is greater than the preset value, the plurality of arrays may be updated to obtain a new plurality of arrays, until an array whose evaluation value is greater than the preset value is obtained.

In a possible implementation, the determining a plurality of arrays anew may include: determining, based on values of the plurality of evaluation values, a mutation rate corresponding to each of the plurality of arrays; and mutating the plurality of arrays based on the mutation rate corresponding to each array, to obtain an updated plurality of arrays. In this implementation of this application, new arrays may be obtained through mutation, until an array whose evaluation value is greater than the preset value is obtained.

In a possible implementation, the mutation rate corresponding to each array includes a shape mutation rate and/or a height mutation rate, the shape mutation rate includes a probability or proportion of shape mutation of each array, and the height mutation rate includes a probability or proportion of height mutation of each array.

Therefore, in this embodiment of this application, the array may be mutated in different dimensions such as a shape or a height, to obtain a plurality of different array structures.

In a possible implementation, the determining a plurality of arrays anew may include: determining, based on values of the plurality of evaluation values, a probability value corresponding to each of the plurality of arrays; performing a plurality of times of sampling on the plurality of arrays based on the probability value corresponding to each array, to obtain a plurality of intermediate structures; determining mutation rates of the plurality of intermediate structures based on evaluation values of the plurality of intermediate structures; and mutating the plurality of intermediate structures based on the mutation rates corresponding to the plurality of intermediate structures, to obtain a new plurality of arrays.

Therefore, in this implementation of this application, the probability value corresponding to each array may be determined based on an evaluation value of the array, then sampling is performed based on the probability value of each array, to select arrays with larger evaluation values, and the selected arrays are mutated to obtain new arrays, until an array whose evaluation value is greater than the preset value is obtained.

In a possible implementation, the method may further include: preparing a color filtering structure between the optical-to-electrical conversion unit and the substrate, where the color filtering structure is divided into a plurality of color filtering regions, each color filtering region covers one corresponding color region, a color corresponding to each color region is the same as a color that passes through a color filtering region covering the color region, and each color filtering region is for filtering out light of colors other than a color corresponding to a color region covered by the color filtering region.

In a possible implementation, the method may further include: preparing a lens between each color filtering region and the substrate. In this application, the lens may be further disposed between each color filtering region and the substrate, to converge light incident to the color filtering region.

In a possible implementation, light of a plurality of spectrum bands corresponding to the plurality of color regions includes one or more of green, red, blue, or infrared light. Therefore, in this implementation of this application, the optical-to-electrical conversion unit can convert optical signals of a plurality of spectrum bands into electrical signals, so as to generate images of more color channels subsequently.

In a possible implementation, a material of the metasurface includes one or more of the following: titanium dioxide, gallium nitride, or silicon carbide.

In a possible implementation, colors corresponding to each color unit include at least two same colors, and columnar structures included in a region that corresponds to each color unit and that is in the metasurface form an angularly symmetric shape.

According to a fourth aspect, this application further provides an electronic device. The electronic device may include the image sensor in the first aspect, the image sensor obtained through preparation in the third aspect, or the like.

According to a fifth aspect, this application provides an array structure determining method applied to an image sensor. The image sensor includes a spectrum splitting and filtering device and an optical-to-electrical conversion unit. The spectrum splitting and filtering device includes a metasurface and a substrate. The optical-to-electrical conversion unit includes an array for optical-to-electrical conversion. The spectrum splitting and filtering device includes the metasurface and the substrate. An array in the metasurface includes a plurality of subunits. Each subunit includes an array including a plurality of columnar structures. Arrays in the metasurface are arranged on the top of the substrate. The bottom of the substrate is disposed on a surface of the optical-to-electrical conversion unit. The metasurface includes at least two media with different refractive indexes. The array of the optical-to-electrical conversion unit is divided into a plurality of color regions. The metasurface is configured to refract incident light to a corresponding color region in the array of the optical-to-electrical conversion unit. The method includes: determining structures of a plurality of arrays; evaluating the structures of the plurality of arrays by using an evaluation function, to obtain an evaluation value corresponding to each of the plurality of arrays, where the evaluation function is a function for calculating light utilization of the spectrum splitting and filtering device when the plurality of arrays are used as the metasurface of the spectrum splitting and filtering device; and determining a structure of the metasurface of the spectrum splitting and filtering device based on the evaluation value.

The array of the optical-to-electrical conversion unit may be divided into a plurality of color units, each color unit includes at least four color regions, each color unit corresponds to one subunit in the metasurface, and each subunit refracts incident light and then transmits refracted light to a color region in a corresponding color unit.

In a possible implementation, the determining an array structure of the metasurface of the spectrum splitting and filtering device based on the evaluation value may include: if the plurality of arrays include at least one array whose evaluation value is greater than a preset value, selecting one array from the at least one array whose evaluation value is greater than the preset value, as the array structure of the metasurface of the spectrum splitting and filtering device; or if the plurality of arrays include no array whose evaluation value is greater than a preset value, updating the plurality of arrays, and determining the array structure of the metasurface of the spectrum splitting and filtering device based on an updated plurality of arrays.

In a possible implementation, the updating the plurality of arrays may include: determining, based on values of the plurality of evaluation values, a mutation rate corresponding to each of the plurality of arrays; and mutating the plurality of arrays based on the mutation rate corresponding to each array, to obtain the updated plurality of arrays.

In a possible implementation, the mutation rate corresponding to each array includes a shape mutation rate and/or a height mutation rate, the shape mutation rate includes a probability or proportion of shape mutation of each array, and the height mutation rate includes a probability or proportion of height mutation of each array.

In a possible implementation, the updating the plurality of arrays may include: determining, based on values of the plurality of evaluation values, a probability value corresponding to each of the plurality of arrays; performing a plurality of times of sampling on the plurality of arrays based on the probability value corresponding to each array, to obtain a plurality of intermediate structures; determining mutation rates of the plurality of intermediate structures based on evaluation values of the plurality of intermediate structures; and mutating the plurality of intermediate structures based on the mutation rates corresponding to the plurality of intermediate structures, to obtain the new plurality of arrays.

In a possible implementation, colors corresponding to each color unit include at least two same colors, and columnar structures included in a region that corresponds to each color unit and that is in the metasurface form an angularly symmetric shape.

According to a sixth aspect, this application provides an array structure construction apparatus, including:

a first determining unit, configured to determine structures of a plurality of arrays;
an evaluation unit, configured to evaluate the structures of the plurality of arrays by using an evaluation function, to obtain an evaluation value corresponding to each of the plurality of arrays, where the evaluation function is a function for calculating light utilization of the spectrum splitting and filtering device when the plurality of arrays are used as a metasurface of the spectrum splitting and filtering device; and
a second determining unit, configured to determine a structure of the metasurface of the spectrum splitting and filtering device based on the evaluation value, where the spectrum splitting and filtering device is included in an image sensor, the image sensor includes the spectrum splitting and filtering device and an optical-to-electrical conversion unit, the spectrum splitting and filtering device includes the metasurface and a substrate, the optical-to-electrical conversion unit includes an array for optical-to-electrical conversion, the spectrum splitting and filtering device includes the metasurface and the substrate, arrays in the metasurface are arranged on the top of the substrate, the bottom of the substrate is disposed on a surface of the optical-to-electrical conversion unit, the metasurface includes the array including at least two media with different refractive indexes, the array in the metasurface includes a plurality of subunits, each subunit includes an array including a plurality of columnar structures, the array of the optical-to-electrical conversion unit is divided into a plurality of color regions, and the metasurface is configured to refract incident light to a corresponding color region in the array of the optical-to-electrical conversion unit.

The array of the optical-to-electrical conversion unit may be divided into a plurality of color units, each color unit includes at least four color regions, each color unit corresponds to one subunit in the metasurface, and each subunit refracts incident light and then transmits refracted light to a color region in a corresponding color unit.

In a possible implementation, the first determining unit is specifically configured to: if the plurality of arrays include at least one array whose evaluation value is greater than a preset value, select one array from the at least one array whose evaluation value is greater than the preset value, as an array structure of the metasurface of the spectrum splitting and filtering device.

The array structure construction apparatus may further include an updating unit, configured to update the plurality of arrays if the plurality of arrays include no array whose evaluation value is greater than a preset value.

The second determining unit is further configured to determine an array structure of the metasurface of the spectrum splitting and filtering device based on an updated plurality of arrays.

In a possible implementation, the updating unit is specifically configured to: determine, based on values of the plurality of evaluation values, a mutation rate corresponding to each of the plurality of arrays; and mutate the plurality of arrays based on the mutation rate corresponding to each array, to obtain the updated plurality of arrays.

In a possible implementation, the updating unit is specifically configured to: determine, based on values of the plurality of evaluation values, a probability value corresponding to each of the plurality of arrays; perform a plurality of times of sampling on the plurality of arrays based on the probability value corresponding to each array, to obtain a plurality of intermediate structures; determine mutation rates of the plurality of intermediate structures based on evaluation values of the plurality of intermediate structures; and mutate the plurality of intermediate structures based on the mutation rates corresponding to the plurality of intermediate structures, to obtain the new plurality of arrays.

In a possible implementation, colors corresponding to each color unit include at least two same colors, and columnar structures included in a region that corresponds to each color unit and that is in the metasurface form an angularly symmetric shape.

According to a seventh aspect, an embodiment of this application provides an array structure construction apparatus. The array structure construction apparatus may also be referred to as a digital processing chip or a chip. The chip includes a processing unit and a communications interface. The processing unit obtains program instructions through the communications interface. The program instructions are executed by the processing unit. The processing unit is configured to perform a processing-related function according to any one of the fifth aspect or the optional implementations of the fifth aspect.

According to an eighth aspect, an embodiment of this application provides a computer-readable storage medium, including instructions. When the instructions are run on a computer, the computer is enabled to perform the method according to any one of the fifth aspect or the optional implementations of the fifth aspect.

According to a ninth aspect, an embodiment of this application provides a computer program product including instructions. When the computer program product is run on a computer, the computer is enabled to perform the method according to any one of the fifth aspect or the possible implementations of the fifth aspect.

**BRIEF DESCRIPTION OF DRAWINGS**

FIG. 1 is a schematic diagram of a structure of an electronic device according to an embodiment of this application;
FIG. 2 is a schematic diagram of a structure of an image sensor according to this application;
FIG. 3 shows a structure of a Bayer color filter according to this application;
FIG. 4 shows a structure of another Bayer color filter according to this application;
FIG. 5 is a schematic diagram of optical signal transmission of a spectral channel;
FIG. 6 is a schematic diagram of refraction and reflection of an optical signal according to this application;
FIG. 7 is a schematic diagram of a structure of a spectrum splitting and filtering device according to this application;
FIG. 8 is a schematic diagram of a structure of an image sensor according to this application;
FIG. 9A is a schematic diagram of a structure of another spectrum splitting and filtering device according to this application;
FIG. 9B is a schematic diagram of a structure of a metasurface according to this application;
FIG. 10 is a schematic diagram of a structure of another image sensor according to this application;
FIG. 11 is a schematic diagram of a structure of an optical-to-electrical conversion unit according to this application;
FIG. 12 is a schematic diagram of a structure of another image sensor according to this application;
FIG. 13 is a schematic diagram of a structure of another image sensor according to this application;
FIG. 14 is a schematic flowchart of an array structure determining method according to this application;
FIG. 15 is a schematic diagram of a structure of another metasurface according to this application;
FIG. 16 is a schematic flowchart of an image sensor preparation method according to this application;
FIG. 17 is a schematic flowchart of an image sensor preparation method according to this application;
FIG. 18 is a schematic diagram of a light utilization spectrum of a spectrum splitting and filtering device according to this application;
FIG. 19A, FIG. 19B, and FIG. 19C are a schematic diagram of distribution of light intensity in an optical-to-electrical conversion unit according to this application; and
FIG. 20 is a schematic diagram of a structure of an array structure construction apparatus according to this application.

**DESCRIPTION OF EMBODIMENTS**

The following describes technical solutions in embodiments of this application with reference to the accompanying drawings in embodiments of this application. Clearly, the described embodiments are merely some rather than all of embodiments of this application. All other embodiments obtained by a person skilled in the art based on embodiments of this application without creative efforts shall fall within the protection scope of this application.

In this specification, the claims, and the accompanying drawings of this application, terms "first", "second", "third", "fourth", and the like (if existent) are intended to distinguish between similar objects, but do not necessarily indicate a specific order or sequence. It should be understood that data used in such a way is interchangeable in proper circumstances, so that embodiments described herein can be implemented in orders other than the order illustrated or described herein. Moreover, terms "include", "comprise", and any other variants thereof mean to cover non-exclusive inclusion. For example, a process, method, system, product, or device that includes a list of steps or units is not necessarily limited to those steps or units, but may include other steps or units not expressly listed or inherent to such a process, method, product, or device.

In the descriptions of this application, "a plurality of" means two or more, unless otherwise precisely and specifically specified.

In this application, unless otherwise expressly specified and limited, terms such as "installed", "connected to", "connected", "fixed", and "set" should be understood in a broad sense, for example, may be a fixed connection, may be a detachable connection, or may be integration; may be a mechanical connection, or may be an electrical connection; and may be a direct connection, may be an indirect connection through an intermediate medium, or may be internal communication between two elements or an interaction relationship between two elements. A person of ordinary skill in the art may understand specific meanings of the foregoing terms in this application based on specific situations.

In the descriptions of this application, it should be understood that an orientation or a location relationship indicated by a term such as "length", "width", "above", "below", "front", "behind", "left", "right", "vertical", "horizontal", "top", "bottom", "inside", or "outside" is an orientation or a location relationship shown based on the accompanying drawings, and is merely intended to describe this application and simplify the description, but is not intended to indicate or imply that an indicated apparatus or component shall have a specific orientation or be formed and operated in a specific orientation, and therefore cannot be understood as a limitation on this application.

Some terms are used in the specification and the claims to refer to particular components. A person skilled in the art should be able to understand that hardware manufacturers may name a same component by using different terms. In the specification and the subsequent claims, components are not differentiated based on a difference between names; instead, a difference between functions of the components is used as a differentiation criterion. The "including" or "comprising" mentioned in the specification and the claims is an open-ended term, and therefore shall be construed as "including but not limited to" or "comprising but not limited to".

For ease of understanding, the following first explains and describes technical terms used in this application.

Metamaterial (metamaterial): In a broad sense, a metamaterial is defined as a complex of artificially designed unit structures with a physical property that is not possessed by conventional natural materials. A physical property of a metamaterial is mainly determined by a structure and arrangement of unit structures of a sub-wavelength (far less than a wavelength).

Metasurface (metasurface): A metasurface is a two-dimensional form of a metamaterial. A metasurface in this application includes:

a focal point, where light rays converge at several points behind a metasurface structure when the light rays are transmitted through the metasurface structure, and the several points at which the light rays converge are focal points; and
a focal length (focal length), also referred to as a focal length, which is a measurement manner for measuring light convergence or divergence in an optical system, and in embodiments of this application, is a distance from an optical center of the metasurface structure to the focal point when an object at infinity is imaged to form a clear image on a focal plane through the metasurface structure, and may also be understood as a perpendicular distance from the optical center of the metasurface structure to the focal plane.

The following describes the technical solutions in this application with reference to the accompanying drawings.

An electronic device provided in embodiments of this application may be a handheld device, a vehicle-mounted device, a wearable device, a computing device, or another processing device connected to a wireless modem, or may be a digital camera (digital camera), a cellular phone (cellular phone), a smartphone (smartphone), a personal digital assistant (personal digital assistant, PDA) computer, a tablet computer, a laptop computer (laptop computer), a machine type communication (machine type communication, MTC) terminal, a point of sales (point of sales, POS), a vehicle-mounted computer, a head-mounted device, a wearable device (such as a wristband or a smartwatch), a security protection device, a virtual reality (virtual reality, VR) device, an augmented reality (augmented reality, AR) device, or another electronic device with an imaging function.

A digital camera is used as an example. A digital camera is a camera that uses a photoelectric sensor to convert an optical image into a digital signal. A conventional camera records an image based on a change in a photosensitive chemical substance on film. By contrast, a sensor of a digital camera is a photosensitive charge-coupled device (charge-coupled device, CCD) or a complementary metal-oxide-semiconductor (complementary metal oxide semiconductor, CMOS). Compared with a conventional camera, a digital camera directly uses an optical-to-electrical conversion image sensor, and therefore has advantages such as higher convenience, quickness, repeatability, and higher timeliness. With the development of CMOS processing technologies, digital cameras are increasingly powerful in function, have almost totally replaced conventional film cameras, and are very widely applied in fields such as consumer electronics, security protection, human-computer interaction, computer vision, and self driving.

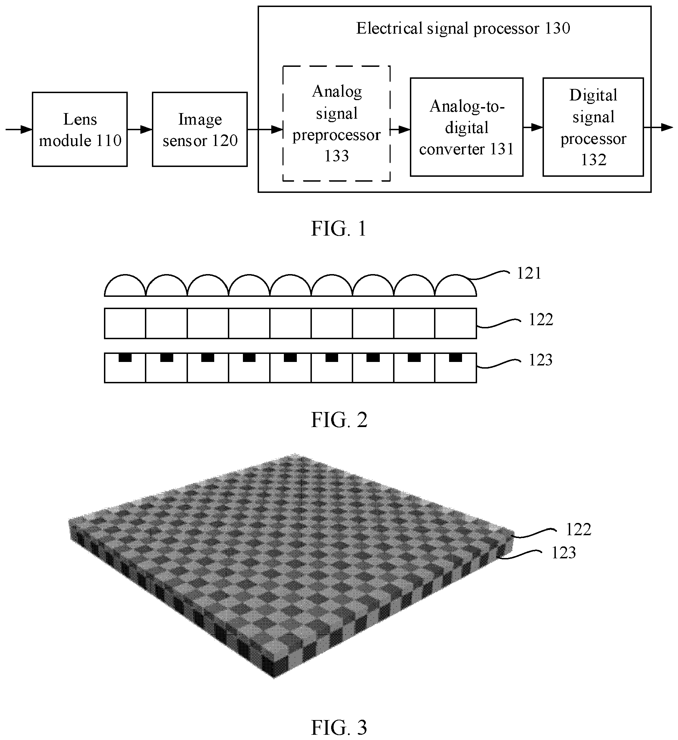

FIG. 1 is a schematic diagram of an electronic device according to this application. As shown in the figure, the electronic device may include a lens (lens) module 110, an image sensor (sensor) 120, and an electrical signal processor 130. The electrical signal processor 130 may include an analog-to-digital (A/D) converter 131 and a digital signal processor 132. The analog-to-digital converter 131 is an analog-signal-to-digital-signal converter, and is configured to convert an analog electrical signal into a digital electrical signal.

It should be understood that the electronic device shown in FIG. 1 is not limited to including the foregoing components, and may further include more or fewer other components, for example, a battery, a flash, a button, and a sensor. Only the electronic device on which the image sensor 120 is installed is used as an example for description in this embodiment of this application, but elements installed on the electronic device are not limited thereto.

Optical signals reflected by a photographed object converge through the lens module 110, and the photographed object is imaged on the image sensor 120. The image sensor 120 converts the optical signal into an analog electrical signal. The analog electrical signal is converted into a digital electrical signal by using the analog-to-digital (A/D) converter 131 in the electrical signal processor 130, and the digital electrical signal is processed by using the digital signal processor 132, for example, the digital electrical signal is optimized through a series of complex mathematical algorithm operations, to finally output an image. The electrical signal processor 130 may further include an analog signal preprocessor 133, configured to preprocess an analog electrical signal transmitted by the image sensor and then output a preprocessed analog electrical signal to the analog-to-digital converter 131.

Performance of the image sensor 120 affects quality of the finally output image. The image sensor 120 may also be referred to as a photosensitive chip, a photosensitive element, or the like, and includes hundreds of thousands to millions of optical-to-electrical conversion elements. When the image sensor is irradiated by light, a charge is generated, and is converted into a digital signal by using an analog-to-digital converter chip.

Usually, the image sensor 120 may obtain color information of an image by using a color filtering system. The color filtering system may be a Bayer color filter (Bayer color filter) system. To be specific, a Bayer color filter covers the optical-to-electrical conversion element in the image sensor 120 to form the color filtering system. The optical-to-electrical conversion element may be a photodiode. The Bayer color filter may also be referred to as a Bayer light filter. FIG. 2 is a schematic diagram of an image sensor based on a Bayer color filter system. The image sensor includes microlenses 121, Bayer color filters 122, and photodiodes 123. The Bayer color filter 122 includes an RGB color filter. RGB color filters are arranged on grids of the photodiodes to form an RGB-mosaic color filtering system. Emulating a biological characteristic that a quantity of green-sensitive photoreceptor cells on a retina of a human eye is the largest, Bayer color filters are usually arranged in an RGGB form. Vision-driven

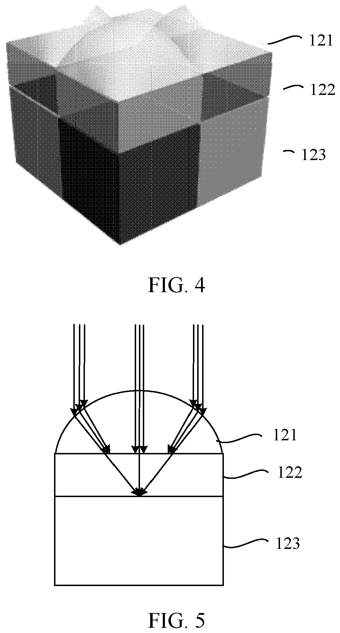

FIG. 3 shows a structure of an image sensor based on a Bayer color filter system, and FIG. 4 is a schematic diagram of a structure of one color pixel unit in the image sensor. As shown in FIG. 3 or FIG. 4, one color pixel unit includes four color filters 122 and four photodiode 123 pixel cells corresponding to the four color filters. The four color filters 122 are arranged in an RGGB form, that is, a red color filter and a blue color filter are diagonally located, and two green color filters are diagonally located. A photosensitive region of a photodiode 123 is at a central location in an area occupied by a photodiode pixel cell, and therefore, the color pixel unit further includes a microlens 121 array above the color filters 122. The microlens 121 array is configured to converge optical signals to the photosensitive region of the photodiode 123, so as to ensure light utilization. The microlens 121 array converges incident optical signals to the four color filters 122 separately. After light filtering through the four color filters 122, filtered optical signals are transmitted to photodiodes 123 respectively covered by the four color filters, and further, light intensity information and approximate color information of an image are obtained at the same time. Subsequently, a color image that is closest to reality can be obtained through optimization and restoration by using a software interpolation algorithm.

However, light utilization of an image sensor based on a Bayer color filter system is quite low. For each color pixel channel, which may also be referred to as a spectral channel, more than 70% of optical signals are filtered out by a Bayer color filter, and only less than 30% of light can reach a photodiode and be converted into an electrical signal for final computational imaging. FIG. 5 is a schematic diagram of luminous flux of a spectral channel in a color pixel unit. As shown in FIG. 5, for a color pixel unit arranged in an RGGB form, when incident light is white light, that is, contains optical signals of all wavelengths ranging from 400 nanometers to 700 nanometers, if a color filter has an ideal color filtering effect, a theoretical maximum value of luminous flux after color filtering is only 1/3 of incident luminous flux; when incident light is red light or blue light, a theoretical maximum value of luminous flux after color filtering is 1/4 of incident luminous flux; when incident light is green light, because there are two green channels, a theoretical maximum value of luminous flux after color filtering is 1/2 of incident luminous flux. Moreover, actually, a color filtering effect of a color filter in reality cannot be perfect, that is, color filtering and light transmission efficiency of the color filter cannot reach 100%, and consequently, actual light utilization is lower. When incident light is white light, total light utilization is only approximately 25%. When incident light is red light or blue light, light utilization is approximately 15%. When incident light is green light, light utilization is approximately 30%.

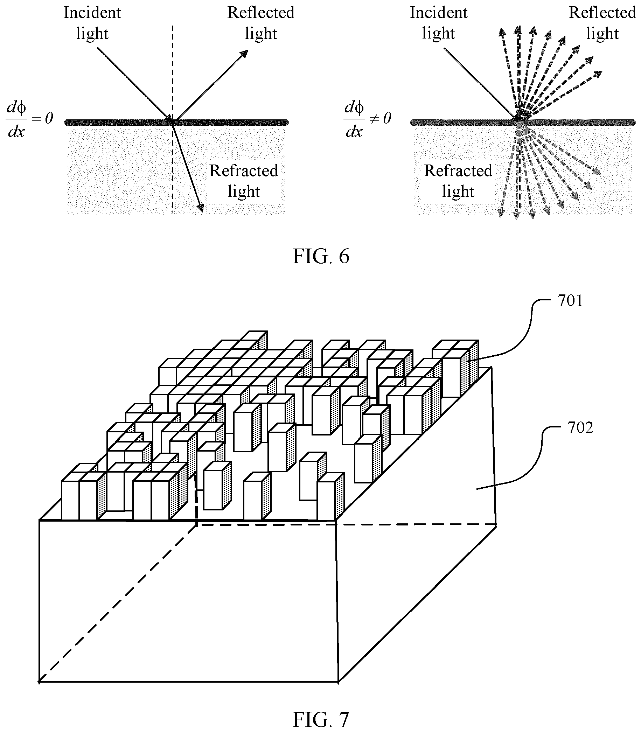

Alternatively, in some scenarios, a metasurface with a spectrum splitting function is used in place of a color filtering system. According to the generalized Snell's law, directions of reflected light and transmitted light depend not only on a refractive index of an interface material, but also on phase gradient distribution on an interface. For example, as shown in FIG. 6, the phase gradient distribution may be calculated by using a formula, such as $n_1 \sin(\theta_2) - n_2 \sin(\theta_1) = \frac{\lambda_0}{2\pi} \frac{d\phi}{dx}$. Required

spatial phase distribution may be calculated based on the spectrum splitting function of the metasurface and the generalized Snell's law, and then, a required geometric phase is generated at a required wavelength by using an anisotropic nanofin structure, thereby implementing the spectrum splitting function. However, all metasurfaces implement the spectrum splitting function by using geometric phases generated by anisotropic nanofin structures, and an inherent characteristic of a geometric phase is that a geometric phase has an effect on only one type of circularly polarized light, whereas another type of circularly polarized light becomes unwanted stray light and cannot be utilized; consequently, a maximum of 50% of light can be utilized. In addition, another inherent characteristic of a nanofin structure is that each nanofin structure generates a same geometric phase for light of different frequencies; therefore, in order to implement the spectrum splitting function for light of different frequencies by using a geometric phase generated by a nanofin structure, nanofins of different sizes need to be placed inside one unit structure, where a nanofin of each size acts on a different spectrum band, thereby achieving a spectrum splitting effect. However, this method will definitely result in very low light utilization because nanofins of different sizes have a negative scattering effect on light that is not in a corresponding operating band.

Therefore, this application provides a spectrum splitting and filtering device applied to an image sensor, to improve light utilization. An efficient pixel-level spectrum splitting function is implemented by using an integrated pixel-level spectrum splitting device, thereby improving light utilization of a color image sensor.

The following separately describes in detail the spectrum splitting and filtering device, an image sensor, and an image sensor preparation method that are provided in this application.

First, this application provides an image sensor. The image sensor includes a spectrum splitting and filtering device and an optical-to-electrical conversion unit. The spectrum splitting and filtering device is configured to refract incident light, so that light of different spectrum bands can be transmitted to corresponding color regions in the optical-to-electrical conversion unit.

A structure of a spectrum splitting and filtering device applied to an image sensor and provided in this application is described.

FIG. 7 is a schematic diagram of a structure of a spectrum splitting and filtering device according to this application.

The spectrum splitting and filtering device includes a metasurface 701 and a substrate 702.

An array of the metasurface 701 is arranged at the top of the substrate 702, or the top of the substrate 702 is for bearing the metasurface.

The metasurface 701 includes an array including at least one columnar structure. The array of the metasurface 701 is configured to refract light. The metasurface 701 includes two media with different refractive indexes. For example, the metasurface may be divided into a plurality of grids, where each grid is filled with one type of medium, such as titanium dioxide or air.

The metasurface includes a plurality of subunits, and each subunit includes an array including a plurality of columnar structures.

Optionally, a top plane of each of the plurality of columnar structures may include one of a triangle, a quadrilateral, a hexagon, or the like, and shapes of all of the plurality of columnar structures may be the same or may be different. This may be understood as follows: A shape of a top plane of each columnar structure on the metasurface is a shape that can be seamlessly spliced, and the top plane is in a direction that faces the metasurface and that is perpendicular to the metasurface.

In addition, because the metasurface includes the array including a plurality of columnar structures, and a shape of a top plane of each columnar structure on the metasurface is a shape that can be seamlessly spliced, a plurality of columnar structures may be spliced into a larger structure because the plurality of columnar structures are close to each other. For example, the columnar structure may be a regular cube structure, and a plurality of regular cubes may be spliced into a rectangular cube shape, another irregular shape, or the like due to adjacency.

The substrate 702 usually includes a material whose light transmittance is greater than a specific value, such as silicon dioxide, polymethyl methacrylate (polymethyl methacrylate, PMMA), or polycarbonate (PC). Alternatively, the substrate 702 may be a hollow structure, to ensure high transmittance.

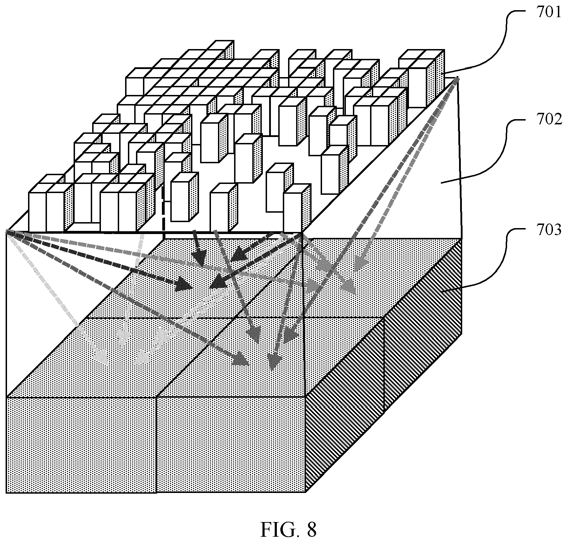

A structure of an image sensor including the spectrum splitting and filtering device may be shown in FIG. 8, where the bottom of the substrate is disposed on a surface or the top of an optical-to-electrical conversion unit 703 in the image sensor. The optical-to-electrical conversion unit 703 includes an array for optical-to-electrical conversion. The array of the optical-to-electrical conversion unit is divided into a plurality of color regions. The metasurface is configured to refract incident light and transmit, through the substrate, refracted light to a corresponding color region in the array of the optical-to-electrical conversion unit. For example, each pixel unit in the optical-to-electrical conversion unit may be divided into four color regions, such as red, green, green, and blue (RGGB). In this case, after incident light is refracted by the metasurface, red light is transmitted to the R region of the optical-to-electrical conversion unit through the substrate, green light is transmitted to the G regions through the substrate, and blue light is transmitted to the B region through the substrate.

The array of the optical-to-electrical conversion unit may be divided into a plurality of color units (which may also be referred to as pixel units or color pixel units). Each color unit includes at least four color regions. Each color unit corresponds to one subunit in the metasurface. Each subunit refracts incident light and then transmits, through the substrate, refracted light to a color region in a corresponding color unit. This may be understood as follows: The metasurface may be understood as being disposed above the surface of the optical-to-electrical conversion unit, a region that is in the metasurface and that corresponds to each color unit includes a plurality of columnar structures, and the plurality of columnar structures are for reflecting incident light to a corresponding color region in the color unit below the plurality of columnar structures.

It may be understood that a structure of the metasurface 701 shown in FIG. 8 is one subunit, and the optical-to-electrical conversion unit 703 may be understood as one color unit including four color regions. One subunit corresponds to one color unit, and the subunit is configured to refract incident light and then transmit, through the substrate 702, refracted light to a corresponding color region in the color unit.

It should be noted that the metasurface may include a plurality of subunits, each subunit includes an array including a plurality of columnar structures, and each subunit may have a same array structure. After a structure of one subunit is determined, a structure of the metasurface in the image sensor is determined. Certainly, each subunit may alternatively have a different array structure. This may be specifically adjusted based on an actual application scenario. In the following implementations of this application, a structure of only one subunit is used as an example for description, and details are not described below again.

Therefore, in the spectrum splitting and filtering device provided in the implementations of this application, light of different colors is refracted by using the array that is in the metasurface and that includes columnar structures, and when the spectrum splitting and filtering device is applied to the sensor, incident light is refracted by the metasurface and then transmitted to a corresponding color region in the optical-to-electrical conversion unit, so as to implement spectrum splitting. This may be understood as follows: The spectrum splitting and filtering device has a medium metasurface or a medium diffraction surface, has a structure characteristic of a second-order two-dimensional barcode type, and has a plurality of spectral channels, so as to implement spectrum splitting for a plurality of colors, and implement a function of efficient spectrum splitting. In addition, the array on a metasurface structure can refract incident light, thereby reducing a scattering phenomenon and improving light utilization. This may also be understood as follows: The metasurface implements diffraction of incident light, so that light of different spectrum bands can be transmitted to corresponding color regions in the optical-to-electrical conversion unit, particularly in a sub-wavelength scenario. The metasurface diffracts incident light, and compared with a Bayer color filter and a nanofin metasurface structure, the metasurface provided in this application can implement diffraction of light of different spectrum bands, thereby improving light utilization.

Specifically, an array structure of the metasurface 701 may include at least two media with different refractive indexes. Using two media as an example, at least one material of the two media may constitute the columnar structure, and constitute the array of the metasurface.

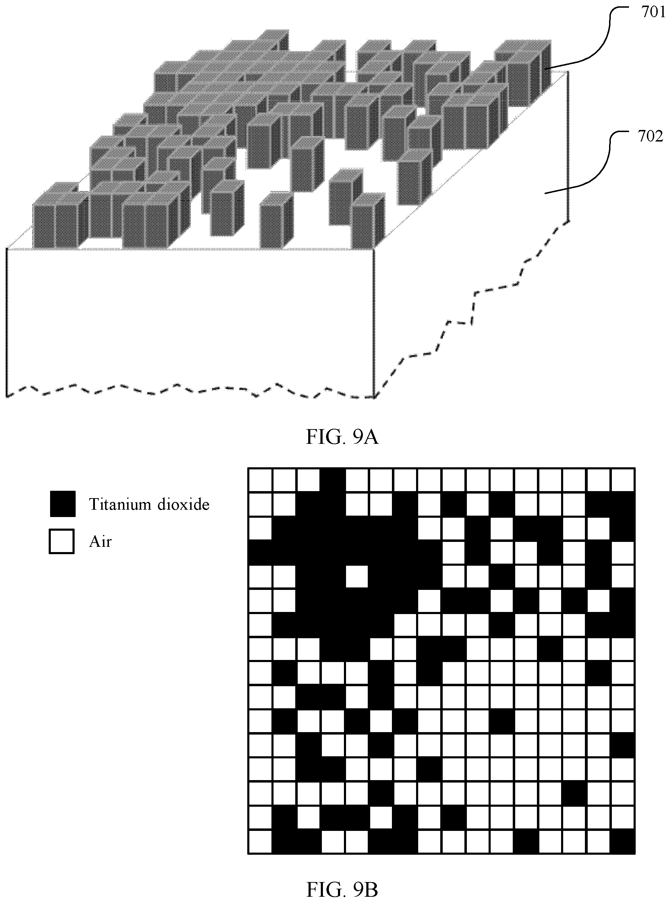

Optionally, a material of the metasurface includes one or more of the following: titanium dioxide, gallium nitride, silicon carbide, or another material with a high refractive index. For example, the array of the metasurface may include columnar structures including titanium dioxide, the plurality of columnar structures constitute the array, and air may be chosen as the other type of medium in the metasurface. For example, the metasurface may include titanium dioxide and air. A refractive index of titanium dioxide is greater than that of air. In this case, a structure of the metasurface may be shown in FIG. 9A, a material of the plurality of columnar structures may be titanium dioxide, and the other type of medium may be air. This may be understood as follows: Air and the columnar structures including titanium dioxide form the array. A top view of the array may be shown in FIG. 9B. This is equivalent to the following: The metasurface may be divided into a plurality of grids, where sizes of the grids may be the same or may be different. An example in which the grids are square network of a same size is used herein. Specifically, for example, a height of the columnar structure on the metasurface 701 may be 500 nm, a width of each square grid may be 100 nm, and the transparent substrate 702 includes silicon dioxide glass and has a thickness of 3.5 $\mu$m. A pixel value of the sensor for which the metasurface is used is 800 nm, that is, a metasurface size corresponding to one pixel unit is 1.6 $\mu$m. When a spectrum splitting device is subsequently prepared, the metasurface may be obtained by filling the grid with a medium. Each type of medium may be in a columnar structure, and the columnar structures may have a same size and shape or different sizes and shapes. Furthermore, one type of medium may be air, and the other type of medium may be a material whose refractive index is different from that of air. This saves materials, and can improve preparation efficiency of the spectrum splitting and filtering device.

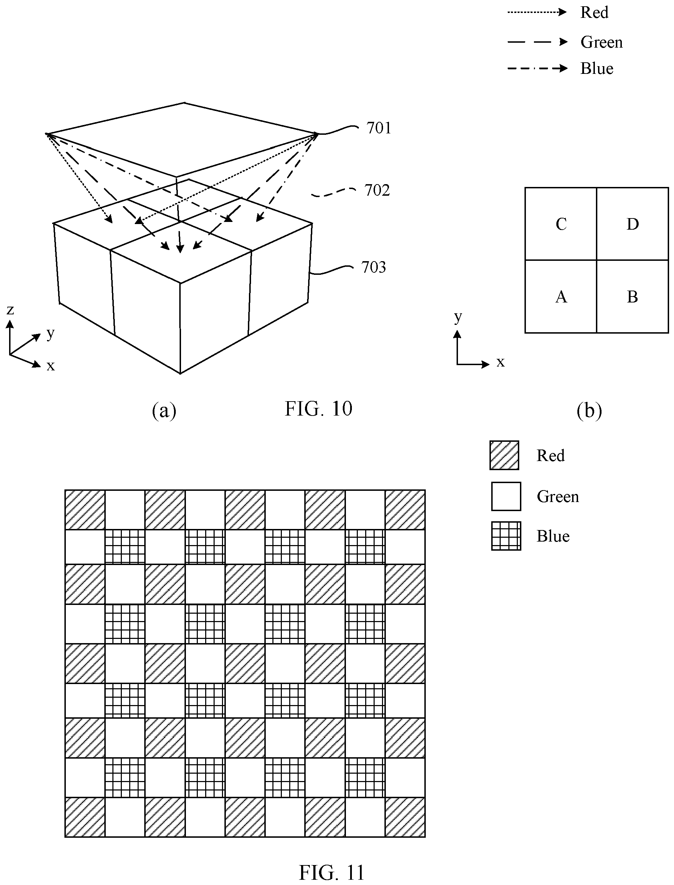

For example, a transmission manner of incident light refracted by the metasurface is described by using an example. As shown in FIG. 10, FIG. 10(a) is a schematic diagram of a structure of one color pixel unit according to an embodiment of this application. As shown in FIG. 10(a), one color pixel unit may include one metasurface 701 and four adjacent optical-to-electrical conversion elements that are two-dimensionally arranged and that are located below the metasurface structure. The four optical-to-electrical conversion elements respectively correspond to an optical-to-electrical conversion element A, an optical-to-electrical conversion element B, an optical-to-electrical conversion element C, and an optical-to-electrical conversion element D in FIG. 10(b). The four optical-to-electrical conversion elements may be arranged in an RGGB manner. For example, the optical-to-electrical conversion element A, the optical-to-electrical conversion element B, the optical-to-electrical conversion element C, and the optical-to-electrical conversion element D may correspond to three spectrum bands of red light, green light, green light, and blue light, respectively. The metasurface 701 may respectively focus red light, green light, and blue light on photosensitive locations of the optical-to-electrical conversion element A, the optical-to-electrical conversion element B, the optical-to-electrical conversion element C, and the optical-to-electrical conversion element D. The following is described with reference to transmission paths of refracted light and reflected light when a spatial transmission phase gradient on the interface shown in FIG. 6 is 0 and transmission paths of refracted light and reflected light when a spatial transmission phase gradient on the interface is not 0. A spatial transmission phase is generated in a tangential direction of the array of the metasurface 701, to obtain a spatial transmission phase gradient. The spatial transmission phase gradient is for transmitting an optical signal of each spectrum band to an optical-to-electrical conversion element corresponding to the spectrum band. In this embodiment of this application, the transmission phase may also be referred to as a transmittance phase.

Due to existence of the spatial transmission phase gradient, an incident optical signal and the metasurface 701 can form a specific resonance effect. When optical signals of different spectrum bands pass through the metasurface 701, different transmission phase changes are generated in the metasurface 701, thereby changing refraction angles of the optical signals. That is, propagation directions of the optical signals are controlled, to transmit the optical signals of different spectrum bands to optical-to-electrical conversion elements corresponding to the different spectrum bands.

It should be understood that the foregoing spectrum band values are merely used as reference data for explanation, and shall not be considered as a limitation on embodiments of this application. A specific frequency range of each spectral channel is subject to an actual overall spectrum design of the image sensor and an actual spectrum response range of the optical-to-electrical conversion element. A quantity of optical-to-electrical conversion elements in one color pixel unit shown in FIG. 10 is merely an example, and does not constitute a limitation on embodiments of this application.

In a possible implementation, colors corresponding to each color unit include at least two same colors, and surfaces of columnar structures included in a metasurface region above each color unit form an angularly symmetric shape.

For example, colors corresponding to every four pixel cells arranged as a matrix in the optical-to-electrical conversion unit may be arranged in an RGGB manner. For example, colors corresponding to color regions in an upper left corner and an upper right corner are green, and colors corresponding to the other two corners are red and blue. Correspondingly, for a structure of the metasurface shown in FIG. 7 to FIG. 9B, a top view of the array including structures on the metasurface may be a symmetric structure, so that incident light can be refracted by the structure of the metasurface and then transmitted to a corresponding color region in the optical-to-electrical conversion unit.

FIG. 11 is a schematic diagram of an array of optical-to-electrical conversion units 220. As shown in FIG. 11, each optical-to-electrical conversion unit 703 may correspond to four optical-to-electrical conversion elements, and the four optical-to-electrical conversion elements are arranged in an RGGB manner. In addition, an anti-emission plate may be further disposed in the optical-to-electrical conversion unit to reduce reflection of an optical signal by the optical-to-electrical conversion unit, thereby further improving light utilization.

It should be understood that a quantity of optical-to-electrical conversion elements in one optical-to-electrical conversion unit 703 shown in FIG. 10 and FIG. 11 is merely an example. An actual quantity of optical-to-electrical conversion elements may be alternatively larger or smaller. The four optical-to-electrical conversion elements mentioned herein constitute no limitation on embodiments of this application.

Therefore, in the implementations of this application, the array including columnar structures is disposed on the metasurface of the spectrum splitting and filtering device, to refract light of different spectrum bands. Compared with a conventional Bayer color filter, in this application, light of different spectrum bands is refracted, so that light of each spectrum band is transmitted to a corresponding region in the optical-to-electrical conversion unit, thereby avoiding low light utilization caused by filtering of the color filter.

Usually, refracting light by using a nanofin structure is effective to only one type of circularly polarized light, and another type of circularly polarized light becomes unwanted stray light and cannot be utilized. Consequently, light utilization is greatly reduced. By contrast, the spectrum splitting and filtering device provided in this application can refract all incident polarized light instead of only one type of circularly polarized light, and has little dependency on polarization. Therefore, the spectrum splitting and filtering device provided in this application can greatly improve light utilization.

In addition, when a nanofin structure is for refracting light, each nanofin structure generates a same geometric phase for light of different frequencies; therefore, in order to implement a spectrum splitting function for light of different frequencies by using a geometric phase generated by a nanofin structure, nanofins of different sizes need to be placed inside one unit structure, where a nanofin of each size acts on a different spectrum band, thereby achieving a spectrum splitting effect. However, this method will definitely result in very low light utilization because nanofins of different sizes have a negative scattering effect on light that is not in a corresponding operating band. By contrast, in the implementations of this application, the array structure of the metasurface may include at least two media with different refractive indexes, and the columnar structure has a required response to light of different spectrum bands, thereby avoiding a problem of low utilization of light that is not refracted because nanofins of different sizes refract light of different spectrum bands. In this way, light utilization is further improved.

Optionally, the surface of the optical-to-electrical conversion unit may further include an anti-reflection layer, or an anti-reflection layer is disposed between the surface of the optical-to-electrical conversion unit and the substrate, so as to reduce reflection of incident light and improve light utilization.

In a possible implementation, a color filtering structure is further disposed between the optical-to-electrical conversion unit 703 and the substrate 702, the color filtering structure is divided into a plurality of color filtering regions, each coloring filtering region covers one corresponding color region, and a color corresponding to each color region is the same as a color that passes through a color filtering region covering the color region. For example, the color filtering structure may be four color filters, or another medium through which light of a specified spectrum band passes.

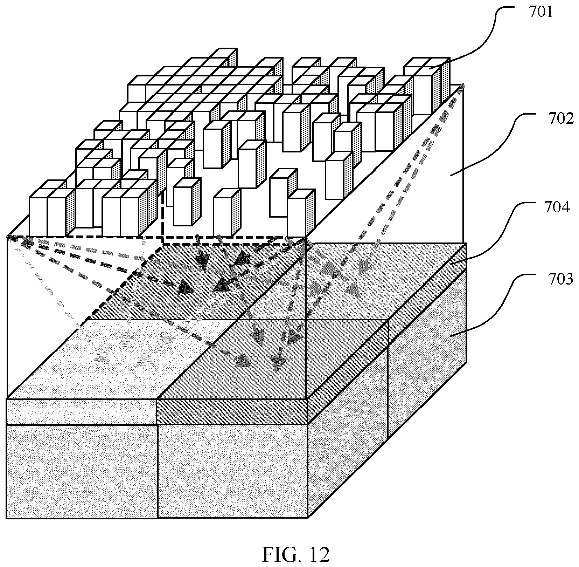

For example, as shown in FIG. 12, a color filter 704 may be disposed between the optical-to-electrical conversion unit and the substrate, and the color filter may be divided into a plurality of color filtering regions for filtering out light other than light of a specific spectrum band. For example, if a color region corresponding to the color filter is green, green can pass through the color filter, and colors other than green are filtered out by the color filter.

Therefore, in this implementation of this application, the color filtering structure may be added, to filter light transmitted to each color region in the optical-to-electrical conversion unit, and filter out light that is not in a specific spectrum band, thereby avoiding interference to optical-signal conversion performed by the optical-to-electrical conversion unit, and further improving light utilization.

In a possible implementation, a lens is further disposed between each color filtering region and the substrate.

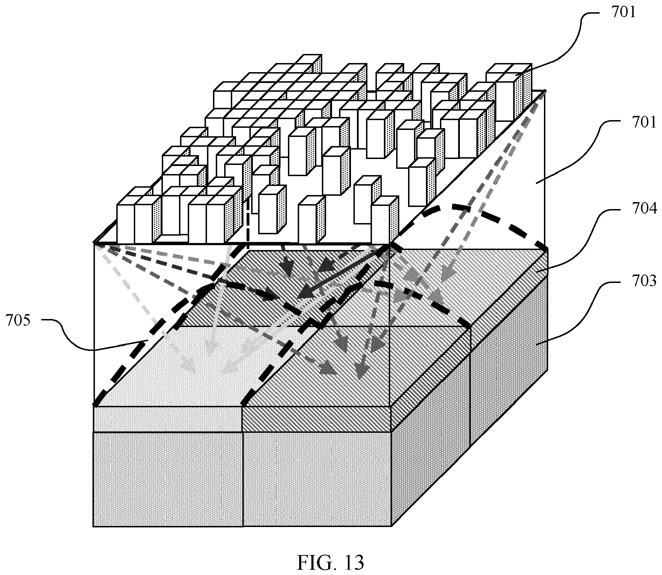

For example, as shown in FIG. 13, a micro convex lens 705 (microlens for short) is disposed between each color filtering region and the substrate. Usually, a size of each microlens is the same as a size of a color filtering region covered by the microlens, so as to converge light transmitted to the color filtering region, thereby reducing scattering of light transmitted to a color region and further improving light utilization. Therefore, in this implementation of this application, the color filter and the microlens may be used in the spectrum splitting and filtering device, to reduce crosstalk of each channel.

In a possible implementation, light of a plurality of spectrum bands of colors corresponding to the plurality of color regions includes one or more of green, red, blue, or infrared (infrared radiation, IR) light.

For example, a quantity of spectrum-splitting spectral channels of the spectrum splitting and filtering device provided in this application is not less than 2, and a spectrum band ranges from ultraviolet to near infrared, depending on a purpose of the image sensor and a spectral response range of a photosensitive layer. A spectrum quantity and channel arrangement depend on the purpose of the image sensor. For example, if the image sensor is used for visible-light imaging, a spectrum band range is a range of 400-700 nm visible light, a spectrum quantity is 3, and channel arrangement is RGGB; if the image sensor is used for multi-spectrum imaging, a spectrum band range is 400-700, and a spectrum quantity may be 7; if the image sensor is used for visible-light and near-infrared imaging, a spectrum band range is 400-1000 nm, a spectrum quantity is 4, and channel arrangement may be RGB and IR. Therefore, in this implementation of this application, spectrum splitting of a plurality of types of visible light or invisible light can be implemented, so as to adapt to a plurality of scenarios. A generalization capability is strong.

A structure of the spectrum splitting and filtering device provided in this application is described above by using an example. It can be learned from the foregoing structure that the metasurface of the spectrum splitting and filtering device plays an important role in improving light utilization, and there may be a plurality of array arrangement manners for the metasurface. The following describes a method for determining an array structure of the metasurface of the spectrum splitting and filtering device.

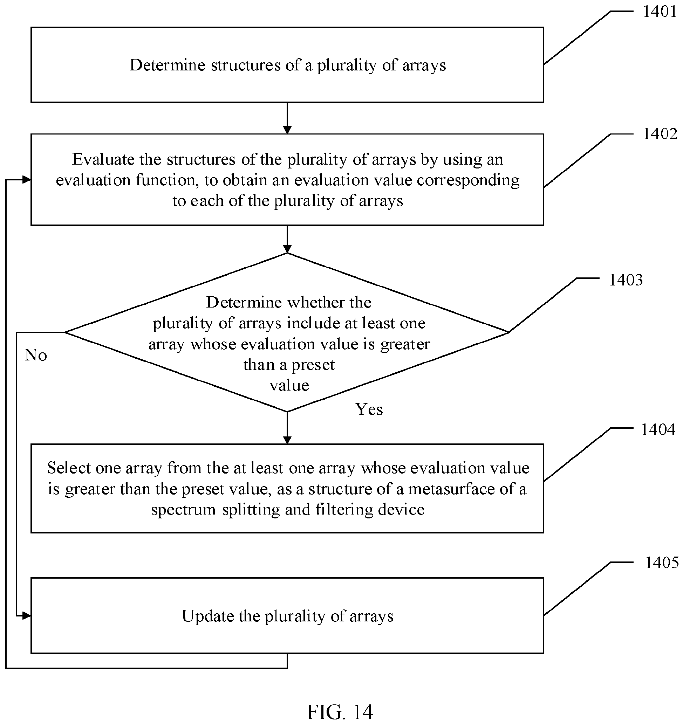

Referring to FIG. 14, this application provides an array structure determining method applied to an image sensor. The image sensor includes a spectrum splitting and filtering device and an optical-to-electrical conversion unit. For the spectrum splitting and filtering device, reference may be made to the spectrum splitting and filtering device in FIG. 7 to FIG. 13, and details are not described herein again. The following describes detailed steps of the array structure determining method applied to the image sensor provided in this application.

1401. Determine structures of a plurality of arrays.

The structures of the plurality of arrays may be obtained by searching preset search space, or may be randomly generated structures. Each array may be of a mesh structure, or may be of a honeycomb structure, or the like. Heights of the structures may be the same or may be different. The height of each structure may also be obtained by searching the preset search space. It may be understood that different array structures and height value ranges may be preset in the search space, and then a plurality of array structures and a height corresponding to each array structure are obtained through sampling from the search space.

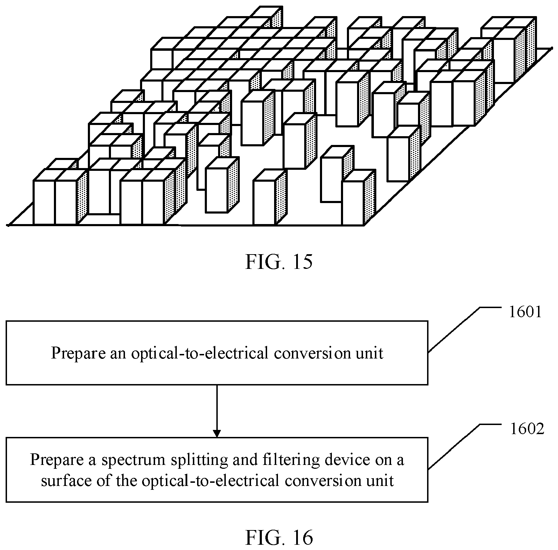

For example, a plurality of array structures may be generated in advance to form the search space, and then usable array structures may be selected based on an actual application scenario, so as to quickly obtain the plurality of arrays, thereby improving efficiency of obtaining the plurality of arrays. For another example, one or more two-dimensional barcode images may be randomly generated, and the plurality of arrays are constructed based on the plurality of two-dimensional barcode images. Specifically, for example, a size of a to-be-constructed metasurface may be preset, then the metasurface is divided into square grids, hexagonal grids, or the like, and then each grid is randomly filled to obtain an array structure, as shown in FIG. 15.

1402. Evaluate the structures of the plurality of arrays by using an evaluation function, to obtain an evaluation value corresponding to each of the plurality of arrays.

The evaluation function is a function for calculating light utilization of the spectrum splitting and filtering device when the plurality of arrays are used as the metasurface of the spectrum splitting and filtering device, to obtain light utilization corresponding to each array, and then an array structure of the metasurface of the spectrum splitting and filtering device is determined based on the evaluation value.

For example, N initial two-dimensional barcode structures may be randomly generated. Each two-dimensional barcode structure includes N*N square regions. Each region may be made of one of two medium materials, for example, air and titanium dioxide, so as to form a second-order matrix including N*N 0/1 to represent the structure. A structure height is a random height within 1 $\mu$m. In this embodiment, 1 represents titanium dioxide, and 0 represents air. A simulation model is established based on a spectrum splitting function of RGGB, and a Maxwell's equation is solved through simulation, to obtain average light utilization through calculation, as the evaluation function below:

$$F = \int_{\lambda_{r1}}^{\lambda_{r2}} T_r d\lambda + \int_{\lambda_{g1}}^{\lambda_{g2}} T_g d\lambda + \int_{\lambda_{b1}}^{\lambda_{b2}} T_b d\lambda$$

Herein, $\lambda_{r1}$ to $\lambda_{r2}$, $\lambda_{g1}$ to $\lambda_{g2}$, and $\lambda_{b1}$ to $\lambda_{b2}$ are respectively spectra of red light, green light, and blue light, and $T_r$, $T_g$, and $T_b$ are respectively transmittances of cell regions corresponding to red light, green light, and blue light. Specifically, for example, image sensors corresponding to the N two-dimensional barcode structures may be generated through simulation, and then light utilization of each simulated image sensor is calculated by using the evaluation function, to obtain light utilization corresponding to each array. Certainly, light utilization may be alternatively calculated by preparing an image sensor corresponding to each array. This is not limited in this application.

1403. Determine whether the plurality of arrays include at least one array whose evaluation value is greater than a preset value, and if yes, perform step 1404, or if no, perform step 1405.

After the evaluation value of each of the plurality of arrays is obtained, it is determined whether the plurality of arrays include an array whose evaluation value is greater than the preset value. If the plurality of arrays include at least one array whose evaluation value is greater than the preset value, one array may be selected from the array whose evaluation value is greater than the preset value, as the array structure of the metasurface of the spectrum splitting and filtering device. If the plurality of arrays include no array whose evaluation value is greater than the preset value, a new array may be obtained, until an array whose evaluation value is greater than the preset value is obtained.

1404. Select one array from the at least one array whose evaluation value is greater than the preset value, as the structure of the metasurface of the spectrum splitting and filtering device.

One array may be selected from the one or more arrays whose evaluation value is greater than the preset value, as the structure of the metasurface of the spectrum splitting and filtering device.

For example, if there are a plurality of arrays whose evaluation values are greater than 50%, an array whose evaluation value is the largest may be selected from the plurality of arrays whose evaluation values are greater than 50%, as the structure of the metasurface of the spectrum splitting and filtering device. Alternatively, one array is randomly selected from the plurality of arrays whose evaluation values are greater than 50%, as the structure of the metasurface of the spectrum splitting and filtering device.

1405. Update the plurality of arrays.

If there is no array whose evaluation value is greater than the preset value in the plurality of arrays, the plurality of arrays are updated, and the structure of the metasurface of the spectrum splitting and filtering device is determined based on an updated plurality of arrays, that is, steps 1402 and 1403 are repeatedly performed until an array whose evaluation value is greater than the preset value is obtained.

There may be a plurality of manners of updating the plurality of arrays. The following describes some possible implementations.

In a possible implementation, a mutation rate corresponding to each of the plurality of arrays may be determined based on values of the plurality of evaluation values. The mutation rate may specifically include a shape mutation rate, a height mutation rate, or the like. The shape mutation rate is a probability or proportion of shape mutation of an array structure. The height mutation rate is a probability or proportion of height mutation of an array. Then, the plurality of arrays are mutated based on the mutation rate corresponding to each array, to obtain the updated plurality of arrays. Specifically, shapes of the plurality of arrays may be mutated based on shape mutation rates, or heights of the plurality of arrays are mutated based on height mutation rates, or the like. Usually, the evaluation value of each array may be used to represent light utilization obtained after the array is substituted into the image sensor through simulation. Higher light utilization indicates a lower corresponding mutation rate. A relationship between light utilization and a mutation rate may be a linear relationship, or may be an exponential relationship, or the like. Specifically, the relationship may be adjusted based on an actual application scenario. A higher mutation rate indicates a larger mutation proportion of the array. For example, if a shape mutation rate is 20%, 20% of regions in an array may be mutated to obtain a mutated array. A specific mutation manner may be rearranging columnar structures in some of the regions in the array, exchanging structures with some of regions in another array, or the like. A specific mutation manner may be adjusted based on an actual application scenario. If a height mutation rate is 10%, an array height is increased or decreased by 10% to obtain a mutated height. A specific mutation manner may be adjusted based on an actual application scenario.

Therefore, in this implementation of this application, shape and height mutation rates of each array may be determined based on an evaluation value of the array, to complete mutation of the array. An array with a larger evaluation value corresponds to a lower mutation rate. In this way, an array structure is adjusted, so that a new array structure is closer to a preset value, so as to subsequently select an array corresponding to higher light utilization.

In another possible implementation, a probability value corresponding to each of the plurality of arrays is determined based on values of the plurality of evaluation values; then, sampling is performed on the plurality of arrays based on the probability value corresponding to each array, to obtain a plurality of intermediate structures; then, mutation rates, including shape mutation rates, height mutation rates, or the like, of the plurality of intermediate structures are determined based on evaluation values of the plurality of intermediate structures; and then, the plurality of intermediate structures are mutated based on the mutation rates corresponding to the plurality of intermediate structures, to obtain a new plurality of arrays. A specific mutation manner may be rearranging columnar structures in some of regions in the array, exchanging structures with some of regions in another array, or the like. A specific mutation manner may be adjusted based on an actual application scenario.

For example, if light utilization corresponding to an array 1 is 25%, light utilization corresponding to an array 2 is 30%, and light utilization corresponding to an array 3 is 26%, then a probability of sampling is set for each array based on a light utilization value corresponding to the array, for example, a probability for the array 1 is 10, a probability for the array 2 is 25%, and a probability for the array 3 is 13%, and then, sampling may be performed for one or more times based on a probability for each array, to obtain a plurality of arrays, that is, a plurality of intermediate structures. Specifically, for example, a manner of setting a corresponding probability for each array may include: $P_i = \dfrac{F_i^n}{\Sigma F_i^n}$, where i represents the $i^{th}$ two-dimensional barcode structure, $F_i$ is an evaluation function of the $i^{th}$ structure, and n may be an integer greater than or equal to 1.

If sampling is performed for a plurality of times, each time of sampling may be performed based on the probability for each array, and arrays that may be obtained through different times of sampling may be the same or may be different. Therefore, in this implementation of this application, a probability for each array may be set based on light utilization corresponding to the array, so that an array corresponding to higher light utilization has a higher probability of being sampled during subsequent sampling, and arrays obtained through sampling are mutated, so as to obtain new arrays.

In another possible implementation, if the search space is preset, and no array whose evaluation value is greater than the preset value is obtained through selection, a plurality of arrays may be obtained by searching the search space again.

In the method provided in this application, an array that meets a light utilization requirement target may be reversely obtained based on the specified light utilization requirement target by using an optimization algorithm such as a genetic algorithm, a simulated annealing algorithm, or gradient descent, so as to improve light utilization of the spectrum splitting and filtering device and the image sensor.

The foregoing describes in detail the spectrum splitting and filtering device, the image sensor, and the array structure determining method applied to the image sensor that are provided in this application. The following describes in detail an image sensor preparation method provided in this application, based on the spectrum splitting and filtering device, the image sensor, and the array structure determining method applied to the image sensor that are described above.

FIG. 16 is a schematic flowchart of an image sensor preparation method according to this application, as described below.

1601. Prepare an optical-to-electrical conversion unit, where the optical-to-electrical conversion unit is configured to convert an optical signal into an electrical signal, the optical-to-electrical conversion unit includes an array for optical-to-electrical conversion, and the array of the optical-to-electrical conversion unit is divided into a plurality of color regions.

1602. Prepare a spectrum splitting and filtering device on a surface of the optical-to-electrical conversion unit.

The spectrum splitting and filtering device includes a metasurface and a substrate. Arrays in the metasurface are arranged on the top of the substrate. The bottom of the substrate is disposed on the surface or the top of the optical-to-electrical conversion unit. The metasurface includes a plurality of subunits, each subunit includes an array including a plurality of columnar structures, and the metasurface includes at least two media with different refractive indexes. The optical-to-electrical conversion unit includes an array for optical-to-electrical conversion. The array of the optical-to-electrical conversion unit is divided into a plurality of color regions. The metasurface is configured to refract incident light to a corresponding color region in the array of the optical-to-electrical conversion unit.

The array of the optical-to-electrical conversion unit may be divided into a plurality of color units, each color unit includes at least four color regions, each subunit in the metasurface corresponds to one color unit, and each subunit refracts incident light and then transmits refracted light to a color region in a corresponding color unit. Usually, array structures in the subunits may be the same or may be different.

For example, the array of the optical-to-electrical conversion unit and arrays of a metasurface structure may be integrated and machined by using a CMOS process. Specifically, for example, the metasurface may include an array including two media: titanium dioxide and air, and columnar structures including titanium dioxide may be filled in the array after an array structure of the metasurface is determined.

For example, step 1602 may include: depositing the substrate on the array of the optical-to-electrical conversion unit, and preparing a microstructure on the substrate.

Therefore, in this implementation of this application, the substrate may be prepared on the surface of the optical-to-electrical conversion unit, and the array of the metasurface may be prepared on the top of the substrate. Light of different colors is refracted by using the array that is in the metasurface and that includes the columnar structures, and incident light is refracted by the metasurface and then transmitted to a corresponding color region in the optical-to-electrical conversion unit, so as to implement spectrum splitting. This may be understood as follows: The spectrum splitting and filtering device has a medium metasurface or a medium diffraction surface, has a structure characteristic of a second-order two-dimensional barcode type, and has a plurality of spectral channels, so as to implement spectrum splitting for a plurality of colors, and implement a function of efficient spectrum splitting. In addition, the array on the metasurface structure can refract incident light, thereby reducing a scattering phenomenon and improving light utilization of an image sensor.

In a possible implementation, a color filtering structure may be further prepared between the optical-to-electrical conversion unit and the substrate. The color filtering structure is divided into a plurality of color filtering regions, each color filtering region covers one corresponding color region, a color corresponding to each color region is the same as a color that passes through a color filtering region covering the color region, and each color filtering region is for filtering out light of colors other than a color corresponding to a color region covered by the color filtering region.

In a possible implementation, a lens may be further prepared between each color filtering region and the substrate.

In a possible implementation, light of a plurality of spectrum bands of colors corresponding to the plurality of color regions includes one or more of green, red, blue, or infrared light.

In a possible implementation, a material of the metasurface includes one or more of the following: titanium dioxide, gallium nitride, or silicon carbide.

In a possible implementation, colors corresponding to each color unit include at least two same colors, and surfaces of columnar structures included in a metasurface region above each color unit form an angularly symmetric shape.

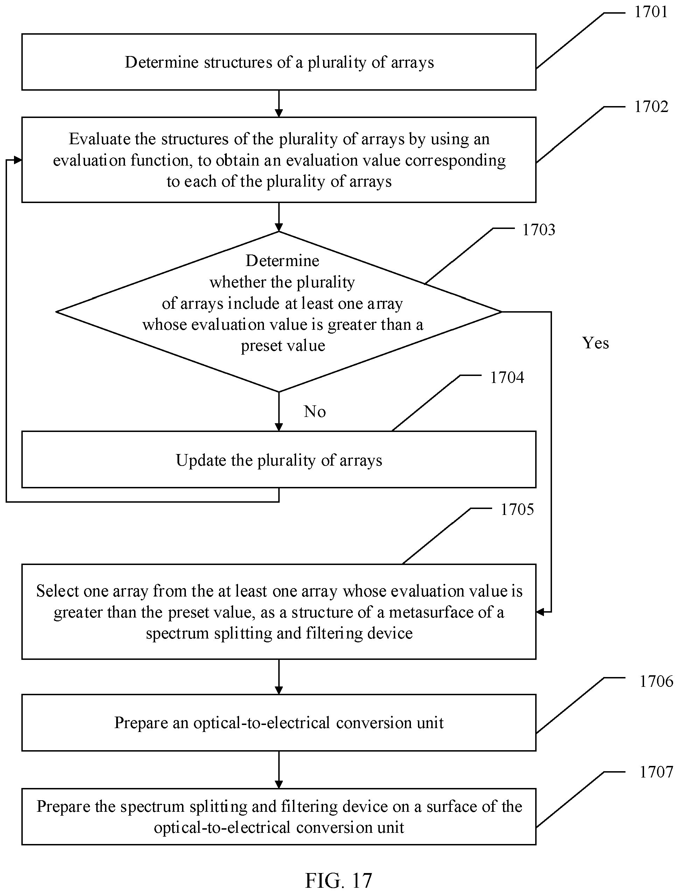

In addition, the array structure of the metasurface may be further constructed before preparation of the metasurface. For example, referring to FIG. 17, the following describes in more detail, with reference to a method for constructing the array structure of the metasurface, a process of the image sensor preparation method provided in this application, as follows.

1701. Determine structures of a plurality of arrays.

1702. Evaluate the structures of the plurality of arrays by using an evaluation function, to obtain an evaluation value corresponding to each of the plurality of arrays.

1703. Determine whether the plurality of arrays include at least one array whose evaluation value is greater than a preset value, and if yes, perform step 1705, or if no, perform step 1704.

1704. Update the plurality of arrays.

1705. Select one array from the at least one array whose evaluation value is greater than the preset value, as the structure of the metasurface of the spectrum splitting and filtering device.

For steps 1701 to 1705, refer to steps 1401 to 1405. Details are not described herein again.

1706. Prepare the optical-to-electrical conversion unit.

1707. Prepare the spectrum splitting and filtering device on the surface of the optical-to-electrical conversion unit.

For steps 1706 and 1707, refer to steps 1601 and 1602. Details are not described herein again.

Therefore, in this implementation of this application, the array structure of the metasurface may be further determined before preparation of the metasurface, so as to obtain an image sensor with higher light utilization. This may be understood as follows: An array that meets a light utilization requirement target may be reversely obtained based on the specified light utilization requirement target by using an optimization algorithm such as a genetic algorithm, a simulated annealing algorithm, or gradient descent, so as to improve light utilization of the spectrum splitting and filtering device and the image sensor.

Light utilization of the image sensor mentioned in this application is described in more detail below by using a more specific application scenario.

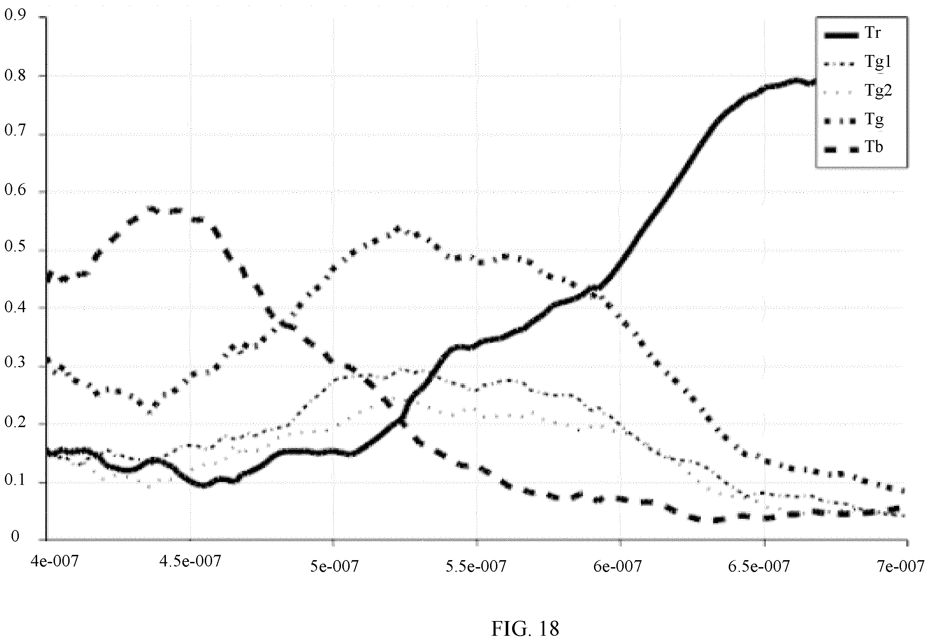

For example, FIG. 18 is a spectrum graph of light utilization of the spectrum splitting device in a visible-light band range of 400-700 nm, where a horizontal coordinate represents a wavelength and a vertical coordinate represents a transmittance. Tb represents a light transmittance for reaching a blue photosensitive pixel cell in a lower right corner, Tg and Tg2 respectively represent light transmittances for reaching two photosensitive pixel cells in an upper right corner and a lower left corner, and Tr represents a transmittance for reaching a red photosensitive pixel cell in an upper left corner. As shown in FIG. 18, this embodiment increases light utilization of visible light to 55.9%, which is approximately 224% of light utilization of a conventional color filter. Light utilization of red light is 73.7%, which is approximately 393% of that of a conventional color filter. Light utilization of green light is 47.9%, which is approximately 127% of that of a conventional color filter. Light utilization of blue light is 47.3%, which is approximately 252% of that of a conventional color filter.

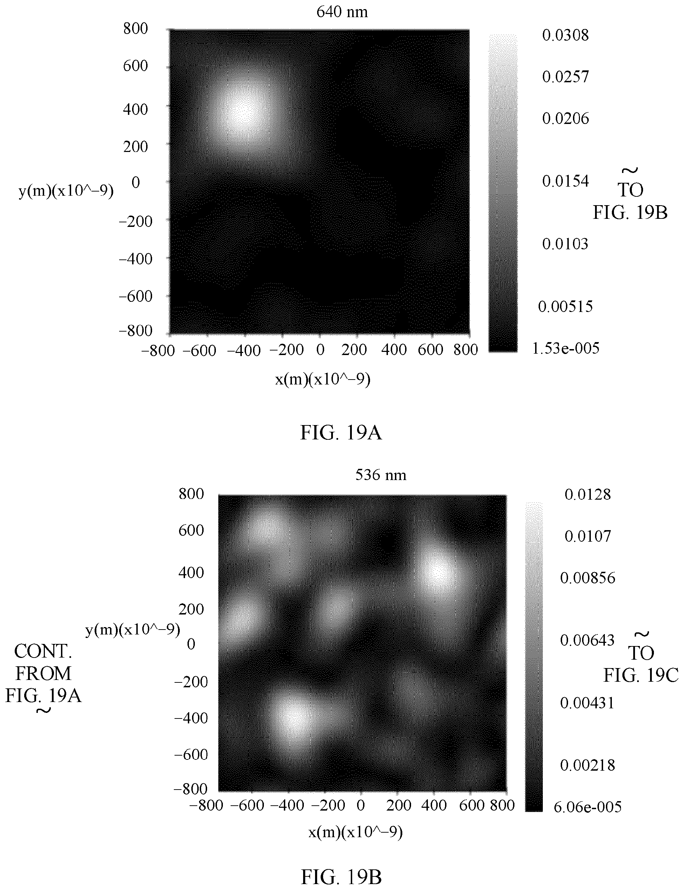

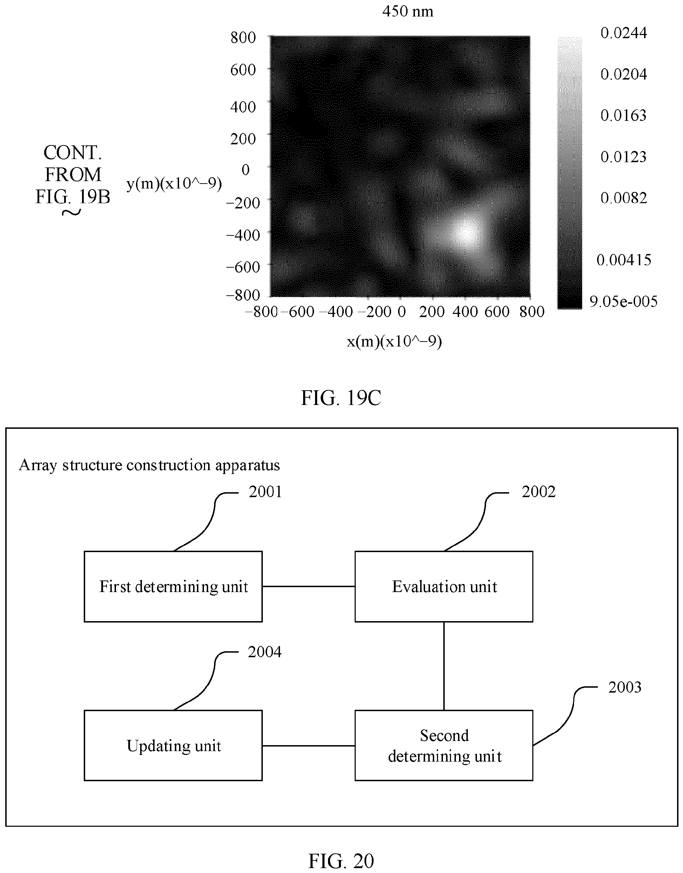

Light intensity distribution on a plane at a distance of 3.5 $\mu$m from the bottom of a medium spectrum splitting device layer is shown in FIG. 19A, FIG. 19B, and FIG. 19C, where (a), (b), and (c) respectively correspond to wavelengths of 450 nm, 536 nm, and 640 nm. It can be seen that light of three colors, namely, red, green, and blue, is respectively focused on four photosensitive pixel cell positions, namely, lower right, lower left, upper right, and upper left, in an RGGB arrangement manner. Spectral crosstalk is eliminated by adding a color filter layer, and an amount of scattered light is comparatively small.

Clearly, it can be learned from the foregoing analysis that light utilization of the image sensor provided in this application is clearly higher than that of a Bayer color filter or a nanofin structure. Therefore, in this implementation of this application, compared with a Bayer color filter that obtains color information by using a color filtering method, a pixel-level spectrum splitting device is used in this application to break through a theoretical limitation of light utilization of a single color filtering system through spectrum splitting, so as to improve light utilization of a color image sensor in principle. For a metasurface technology of a nanofin structure, a function-driven reverse design algorithm is used in the present invention to design a structure of a second-order two-dimensional barcode type, which has advantages of high spectrum splitting efficiency, low polarization dependency, and matching a smaller photosensitive pixel cell. Furthermore, light utilization of the image sensor is improved, thereby increasing a signal-to-noise ratio during photographing performed by using the image sensor, improving quality of an image photographed under a weak-light condition, and improving performance of photographing under a weak-light condition.

Referring to FIG. 20, this application further provides an array structure construction apparatus, configured to perform the method in FIG. 14, where the apparatus may include:

a first determining unit 2001, configured to determine structures of a plurality of arrays;

an evaluation unit 2002, configured to evaluate the structures of the plurality of arrays by using an evaluation function, to obtain an evaluation value corresponding to each of the plurality of arrays, where the evaluation function is a function for calculating light utilization of a spectrum splitting and filtering device when the plurality of arrays are used as a metasurface of the spectrum splitting and filtering device; and

a second determining unit 2003, configured to determine a structure of the metasurface of the spectrum splitting and filtering device based on the evaluation value, where the spectrum splitting and filtering device is included in an image sensor, the image sensor includes the spectrum splitting and filtering device and an optical-to-electrical conversion unit, the spectrum splitting and filtering device includes the metasurface and a substrate, the optical-to-electrical conversion unit includes an array for optical-to-electrical conversion, the spectrum splitting and filtering device includes the metasurface and the substrate, arrays in the metasurface are arranged on the top of the substrate, the bottom of the substrate is disposed on a surface or the top of the optical-to-electrical conversion unit, the metasurface includes the array including at least two media with different refractive indexes, the array in the metasurface includes an array including at least one columnar structure, the array of the optical-to-electrical conversion unit is divided into a plurality of color regions, and the metasurface is configured to refract incident light to a corresponding color region in the array of the optical-to-electrical conversion unit.

The array of the optical-to-electrical conversion unit may be divided into a plurality of color units, each color unit includes at least four color regions, each color unit corresponds to one subunit, and each subunit refracts incident light and then transmits refracted light to a color region in a corresponding color unit.

In a possible implementation, the first determining unit 2001 is specifically configured to: if the plurality of arrays include at least one array whose evaluation value is greater than a preset value, select one array from the at least one array whose evaluation value is greater than the preset value, as an array structure of the metasurface of the spectrum splitting and filtering device.

The array structure construction apparatus may further include an updating unit 2004, configured to update the plurality of arrays if the plurality of arrays include no array whose evaluation value is greater than a preset value.

The second determining unit is further configured to determine an array structure of the metasurface of the spectrum splitting and filtering device based on an updated plurality of arrays.

In a possible implementation, the updating unit 2004 is specifically configured to: determine, based on values of the plurality of evaluation values, a mutation rate corresponding to each of the plurality of arrays; and mutate the plurality of arrays based on the mutation rate corresponding to each array, to obtain the updated plurality of arrays.

In a possible implementation, the updating unit 2004 is specifically configured to: determine, based on values of the plurality of evaluation values, a probability value corresponding to each of the plurality of arrays; perform a plurality of times of sampling on the plurality of arrays based on the probability value corresponding to each array, to obtain a plurality of intermediate structures; determine mutation rates of the plurality of intermediate structures based on evaluation values of the plurality of intermediate structures; and mutate the plurality of intermediate structures based on the mutation rates corresponding to the plurality of intermediate structures, to obtain the new plurality of arrays.

In a possible implementation, colors corresponding to each color unit include at least two same colors, and surfaces of columnar structures included in a metasurface region above each color unit form an angularly symmetric shape.

Therefore, every at least four color regions arranged into a matrix may correspond to at least two same colors, and colors corresponding to two symmetric color regions may be the same. This embodiment provides a possible arrangement manner applicable to the arrays of the metasurface.

The foregoing descriptions are merely optional embodiments of this application, but are not intended to limit this application. Any modification, equivalent replacement, improvement, or the like made without departing from the spirit and principle of this application shall fall within the protection scope of this application.

**Claims**

1. An image sensor, comprising a metasurface, a substrate, and an optical-to-electrical conversion unit, wherein
   the metasurface comprises a plurality of subunits, each subunit comprises an array comprising a plurality of columnar structures, arrays in the metasurface are arranged on the top of the substrate, the bottom of the substrate is disposed on a surface of the optical-to-electrical conversion unit, the metasurface comprises at least two media with different refractive indexes, the optical-to-electrical conversion unit comprises an array for optical-to-electrical conversion, the array of the optical-to-electrical conversion unit is divided into a plurality of color units, each color unit comprises at least four color regions, each color unit corresponds to one of the plurality of subunits, the metasurface is configured to refract incident light and transmit, through the substrate, refracted light to a corresponding color region in the array of the optical-to-electrical conversion unit, and each subunit refracts incident light and then transmits, through the substrate, refracted light to a color region in a corresponding color unit.

2. The image sensor according to claim 1, wherein a color filtering structure is further disposed between the optical-to-electrical conversion unit and the substrate, the color filtering structure is divided into a plurality of color filtering regions, each color filtering region covers one corresponding color region, and a color corresponding to each color region is the same as a color that passes through a color filtering region covering the color region.

3. The image sensor according to claim 2, wherein a lens is further disposed between each color filtering region and the substrate.

4. The image sensor according to any one of claims 1 to 3, wherein light of a plurality of spectrum bands corresponding to the plurality of color regions comprises one or more of green, red, blue, or infrared light.

5. The image sensor according to any one of claims 1 to 4, wherein a material of the metasurface comprises one or more of the following: titanium dioxide, gallium nitride, or silicon carbide.

6. The image sensor according to any one of claims 1 to 5, wherein colors corresponding to each color unit comprise at least two same colors, and the plurality of columnar structures comprised in the subunit corresponding to each color unit form an angularly symmetric shape.

7. A spectrum splitting and filtering device, comprising a metasurface and a substrate, wherein
   the metasurface comprises a plurality of subunits, each subunit comprises an array comprising a plurality of columnar structures, arrays in the metasurface are arranged on the top of the substrate, the metasurface comprises at least two media with different refractive indexes, the metasurface is configured to refract incident light, and the substrate is configured to transmit light refracted by the metasurface.

8. The spectrum splitting and filtering device according to claim 7, wherein the spectrum splitting and filtering device is applied to an image sensor, the image sensor comprises an optical-to-electrical conversion unit, the substrate is disposed on a surface of the optical-to-electrical conversion unit, the optical-to-electrical conversion unit comprises an array for optical-to-electrical conversion, the array of the optical-to-electrical conversion unit is divided into a plurality of color units, each color unit comprises at least four color regions, each color unit corresponds to one of the plurality of subunits, the metasurface refracts incident light and transmits, through the substrate, refracted light to a corresponding color region in the array of the optical-to-electrical conversion unit, and each subunit refracts incident light and transmits refracted light to a color region in a corresponding color unit.

9. The spectrum splitting and filtering device according to claim 8, wherein colors corresponding to each color unit comprise at least two same colors, and columnar structures comprised in a region that corresponds to each color unit and that is in the metasurface form an angularly symmetric shape.

10. The spectrum splitting and filtering device according to any one of claims 7 to 9, wherein
a color filtering structure is further disposed between the optical-to-electrical conversion unit and the substrate, the color filtering structure is divided into a plurality of color filtering regions, each color filtering region covers one corresponding color region, and a color corresponding to each color region is the same as a color that passes through a color filtering region covering the color region.

11. An image sensor preparation method, comprising:

preparing an optical-to-electrical conversion unit, wherein the optical-to-electrical conversion unit is configured to convert an optical signal into an electrical signal, the optical-to-electrical conversion unit comprises an array for optical-to-electrical conversion, and the array of the optical-to-electrical conversion unit is divided into a plurality of color regions; and
preparing a spectrum splitting and filtering device on a surface of the optical-to-electrical conversion unit, wherein the spectrum splitting and filtering device comprises a metasurface and a substrate, the metasurface comprises a plurality of subunits, each subunit comprises an array comprising a plurality of columnar structures, arrays in the metasurface are arranged on the top of the substrate, the bottom of the substrate is disposed on the surface of the optical-to-electrical conversion unit, the metasurface comprises at least two media with different refractive indexes, the surface of the optical-to-electrical conversion unit is a face for receiving an optical signal, the array of the optical-to-electrical conversion unit is divided into a plurality of color units, each color unit comprises at least four color regions, each color unit corresponds to one of the plurality of subunits, the metasurface is configured to refract incident light to a corresponding color region in the array of the optical-to-electrical conversion unit, and each subunit refracts incident light and then transmits, through the substrate, refracted light to a color region in a corresponding color unit.

12. The method according to claim 11, wherein before the preparing a spectrum splitting and filtering device on a surface of the optical-to-electrical conversion unit, the method further comprises:

determining a plurality of arrays, and using the plurality of arrays as a structure of the metasurface of the spectrum splitting and filtering device, to obtain a plurality of spectrum splitting structures;
obtaining a plurality of evaluation values in one-to-one correspondence with the plurality of spectrum splitting structures by using a preset evaluation function, wherein the evaluation function is a function for calculating light utilization of the spectrum splitting structures; and
if the plurality of evaluation values comprise at least one evaluation value greater than a preset value, selecting a first spectrum splitting structure as a structure of the spectrum splitting and filtering device from the plurality of spectrum splitting structures, wherein an evaluation value of the first spectrum splitting structure is greater than the preset value.

13. The method according to claim 12, wherein the method further comprises:
if the plurality of evaluation values do not comprise at least one evaluation value greater than a preset value, determining a plurality of arrays anew, and determining a spectrum splitting structure as a structure of the spectrum splitting and filtering device based on the plurality of arrays determined anew.

14. The method according to claim 13, wherein the determining a plurality of arrays anew comprises:

determining, based on values of the plurality of evaluation values, a mutation rate corresponding to each of the plurality of arrays; and
mutating the plurality of arrays based on the mutation rate corresponding to each array, to obtain an updated plurality of arrays.

**15.** The method according to claim 14, wherein the mutation rate corresponding to each array comprises a shape mutation rate and/or a height mutation rate, the shape mutation rate comprises a probability or proportion of shape mutation of each array, and the height mutation rate comprises a probability or proportion of height mutation of each array.

**16.** The method according to claim 13, wherein the determining a plurality of arrays anew comprises:

determining, based on values of the plurality of evaluation values, a probability value corresponding to each of the plurality of arrays;
performing a plurality of times of sampling on the plurality of arrays based on the probability value corresponding to each array, to obtain a plurality of intermediate structures;
determining mutation rates of the plurality of intermediate structures based on evaluation values of the plurality of intermediate structures; and
mutating the plurality of intermediate structures based on the mutation rates corresponding to the plurality of intermediate structures, to obtain a new plurality of arrays.

**17.** The method according to any one of claims 11 to 16, wherein the method further comprises:
preparing a color filtering structure between the optical-to-electrical conversion unit and the substrate, wherein the color filtering structure is divided into a plurality of color filtering regions, each color filtering region covers one corresponding color region, a color corresponding to each color region is the same as a color that passes through a color filtering region covering the color region, and each color filtering region is for filtering out light of colors other than a color corresponding to a color region covered by the color filtering region.

**18.** The method according to claim 17, wherein the method further comprises:
preparing a lens between each color filtering region and the substrate.

**19.** The method according to any one of claims 11 to 18, wherein light of a plurality of spectrum bands corresponding to the plurality of color regions comprises one or more of green, red, blue, or infrared light.

**20.** The method according to any one of claims 11 to 19, wherein a material of the metasurface comprises one or more of the following: titanium dioxide, gallium nitride, or silicon carbide.

**21.** The method according to any one of claims 11 to 20, wherein colors corresponding to each color unit comprise at least two same colors, and columnar structures comprised in a region that corresponds to each color unit and that is in the metasurface form an angularly symmetric shape.

**22.** An electronic device, wherein the electronic device comprises the image sensor according to any one of claims 1 to 6.

Electrical signal processor 130

| Lens module 110 | Image sensor 120 | Analog signal preprocessor 133 | Analog-to-digital converter 131 | Digital signal processor 132 |

FIG. 1

121

122

123

FIG. 2

122

123

FIG. 3

121
122
123

FIG. 4

121
122
123

FIG. 5

$$\frac{d\phi}{dx} = 0$$

Incident light
Reflected light
Refracted light

$$\frac{d\phi}{dx} \neq 0$$

Incident light
Reflected light
Refracted light

FIG. 6

701

702

FIG. 7

701
702
703

FIG. 8

701

702

FIG. 9A

■ Titanium dioxide

□ Air

FIG. 9B

Red

Green

Blue

C | D

A | B

(a)　　　　FIG. 10　　　　(b)

Red

Green

Blue

FIG. 11

701

702

704

703

FIG. 12

FIG. 13

1401

Determine structures of a plurality of arrays

1402

Evaluate the structures of the plurality of arrays by using an evaluation function, to obtain an evaluation value corresponding to each of the plurality of arrays

1403

Determine whether the plurality of arrays include at least one array whose evaluation value is greater than a preset value

No

Yes

1404

Select one array from the at least one array whose evaluation value is greater than the preset value, as a structure of a metasurface of a spectrum splitting and filtering device

1405

Update the plurality of arrays

FIG. 14

FIG. 15

```
                                                    ┌─────────────── 1601
┌──────────────────────────────────────────────────┐
│                                                    │
│      Prepare an optical-to-electrical conversion unit │
│                                                    │
└──────────────────────────────────────────────────┘
                          │
                          ▼
                                                    ┌─────────────── 1602
┌──────────────────────────────────────────────────┐
│      Prepare a spectrum splitting and filtering device on a │
│      surface of the optical-to-electrical conversion unit │
└──────────────────────────────────────────────────┘
```

FIG. 16

1701

Determine structures of a plurality of arrays

1702

Evaluate the structures of the plurality of arrays by using an evaluation function, to obtain an evaluation value corresponding to each of the plurality of arrays

1703

Determine whether the plurality of arrays include at least one array whose evaluation value is greater than a preset value

Yes

No

1704

Update the plurality of arrays

1705

Select one array from the at least one array whose evaluation value is greater than the preset value, as a structure of a metasurface of a spectrum splitting and filtering device

1706

Prepare an optical-to-electrical conversion unit

1707

Prepare the spectrum splitting and filtering device on a surface of the optical-to-electrical conversion unit

FIG. 17

FIG. 18

640 nm

y(m)(x10^–9)

x(m)(x10^–9)

0.0308

0.0257

0.0206

0.0154 ~TO
FIG. 19B

0.0103

0.00515

1.53e-005

FIG. 19A

536 nm

CONT.
FROM
FIG. 19A
~

y(m)(x10^–9)

x(m)(x10^–9)

0.0128

0.0107

0.00856

0.00643 ~TO
FIG. 19C

0.00431

0.00218

6.06e-005

FIG. 19B

450 nm

CONT.
FROM
FIG. 19B
~

FIG. 19C

FIG. 20

| INTERNATIONAL SEARCH REPORT | International application No. |
|---|---|
| | **PCT/CN2020/141893** |

**A. CLASSIFICATION OF SUBJECT MATTER**

H01L 27/146(2006.01)i

According to International Patent Classification (IPC) or to both national classification and IPC

**B. FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNABS, DWPI, SIPOABS, CNKI: 分色, 光电转换, 超表面, 衍射, 图像传感器, 折射, 滤色, 图像, 传感器, color, filter, face, refraction, image, sensor

**C. DOCUMENTS CONSIDERED TO BE RELEVANT**

| Category* | Citation of document, with indication, where appropriate, of the relevant passages | Relevant to claim No. |
|---|---|---|
| X | CN 110400816 A (HUAIAN IMAGING DEVICE MFT CORP.) 01 November 2019 (2019-11-01) description, paragraphs [0039]-[0080] | 1-22 |
| X | CN 1815747 A (DONGBUANAM SEMICONDUCTOR INC.) 09 August 2006 (2006-08-09) claims 1-7, and figure 3 | 1-22 |
| X | CN 104282706 A (SONY CORPORATION) 14 January 2015 (2015-01-14) claims 1-9 | 1-22 |
| X | CN 102130138 A (SEMICONDUCTOR MANUFACTURING INTERNATIONAL (SHANGHAI) CORPORATION) 20 July 2011 (2011-07-20) claims 1-8, figure 2 | 1-22 |
| A | US 2015171136 A1 (TAIWAN SEMICONDUCTOR MFG CO., LTD.) 18 June 2015 (2015-06-18) entire document | 1-22 |

☐ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **11 March 2021** | **02 April 2021** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088** **China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2020/141893**

| Patent document cited in search report | | | Publication date (day/month/year) | Patent family member(s) | | | Publication date (day/month/year) |
|---|---|---|---|---|---|---|---|
| CN | 110400816 | A | 01 November 2019 | None | | | |
| CN | 1815747 | A | 09 August 2006 | US | 7262072 | B2 | 28 August 2007 |
| | | | | KR | 20060073186 | A | 28 June 2006 |
| | | | | CN | 100474604 | C | 01 April 2009 |
| | | | | US | 2006138497 | A1 | 29 June 2006 |
| CN | 104282706 | A | 14 January 2015 | US | 9356063 | B2 | 31 May 2016 |
| | | | | CN | 104282706 | B | 22 March 2019 |
| | | | | JP | 2015018906 | A | 29 January 2015 |
| | | | | US | 2015015758 | A1 | 15 January 2015 |
| CN | 102130138 | A | 20 July 2011 | US | 2012012960 | A1 | 19 January 2012 |
| | | | | US | 8319303 | B2 | 27 November 2012 |
| | | | | CN | 102130138 | B | 02 January 2013 |
| US | 2015171136 | A1 | 18 June 2015 | US | 9543352 | B2 | 10 January 2017 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2019130438 W

- CN 2020130020 W